# EUROPEAN PATENT SPECIFICATION

(11) **EP 4 276 883 B1**
(45) Date of publication and mention of the grant of the patent: **22.10.2025**
(21) Application number: 22868533.5
(22) Date of filing: 12.01.2022
(51) Int. Cl.: H10B 12/00

(54) **MEMORY DEVICE AND FORMING METHOD THEREFOR**
SPEICHERVORRICHTUNG UND HERSTELLUNGSVERFAHREN DAFÜR
DISPOSITIF DE MÉMOIRE ET PROCÉDÉ DE FORMATION ASSOCIÉ

(30) Priority: 15.09.2021 CN 202111079099
(43) Date of publication of application: 15.11.2023
(73) Proprietor: Changxin Memory Technologies, Inc., Hefei City, Anhui Province 230601 (CN)
(72) Inventor: GUO, Shuai, Hefei City, Anhui Province 230601 (CN)
(74) Representative: Gulde & Partner
(86) International application number: PCT/CN2022/071629
(87) International publication number: WO 2023/040152

(56) References cited:
- CN-A- 110 880 510
- CN-A- 113 053 900
- US-A1- 2012 094 454
- US-A1- 2012 094 454
- US-A1- 2012 214 297
- US-A1- 2014 175 555
- US-A1- 2020 286 906

## Description

### CROSS-REFERENCE TO RELATED APPLICATION

This application claims priority to Chinese Patent Application No. 202111079099.5, filed on September 15, 2021 and entitled "SEMICONDUCTOR STRUCTURE AND FORMING METHOD THEREFOR".

### TECHNICAL FIELD

The application relates to the field of memories, and in particular to a storage device and a method for forming a storage device.

### BACKGROUND

ADynamic Random Access Memory, DRAM is a semiconductor storage device commonly used in a computer and is composed of many repeated storage cells. Each storage cell generally includes a capacitor and a transistor. A gate of the transistor is connected to a word line, a drain area of the transistor is connected to a bit line, and a source of the transistor is connected to the capacitor. A voltage signal on the word line can control turning on or turning off of the transistor, and then the data information stored in the capacitor is read through the bit line, or the data information is written into the capacitor through the bit line for storage.

In order to improve the integration of the storage structure, the transistors in the existing Dynamic Random Access Memory, DRAM generally adopt a trench-type transistor structure. However, the line width of the existing trench-type transistor structure has been reduced to the limit, so that the storage capacity of the DRAM cannot be further improved. Therefore, an urgent problem to be solved by those skilled in the art is how to further improve the storage capacity and the storage density of the DRAM. Background may be found in US20120094454A1 and US20140175555A1.

### SUMMARY

A method of forming a DRAM device according to the invention is presented in claim 1 and a DRAM device according to the invention is presented in claim 9. Embodiments of the invention are presented in the dependent claims.

In view of this, some embodiments of the application provide a method for forming a storage device, which includes the following operations.

A semiconductor substrate is provided, and a plurality of active areas are formed in the semiconductor substrate, in which the plurality of active areas are spaced apart from each other by a plurality of first trenches and a plurality of second trenches extending along a first direction and a plurality of third trenches extending along a second direction, the plurality of first trenches and the plurality of second trenches communicate with the plurality of third trenches, the plurality of first trenches and the plurality of second trenches are spaced apart from each other in the second direction, a depth of each of the plurality of second trenches is less than a depth of each of the plurality of first trenches, and a depth of a region of each of the plurality of third trenches other than a communication region of each of the plurality of third trenches with each of the plurality of second trenches is greater than the depth of each of the plurality of second trenches.

A bit line area is formed in the semiconductor substrate at a bottom portion of each of the plurality of second trenches and at a bottom portion of the communication region of each of the plurality of third trenches with each of the plurality of second trenches.

A first isolation layer is formed in each of plurality of the first trenches and each of the plurality of third trenches, in which a surface of the first isolation layer is lower than a surface of each of the plurality of active areas.

A gate dielectric layer surrounding the plurality of active areas is formed on the surfaces of the plurality of active areas.

A plurality of metal gates surrounding the plurality of active areas are formed on a surface of the gate dielectric layer arranged on side walls of the plurality of active areas, in which a top surface of each of the plurality of metal gates is lower than a top surface of each of the plurality of active areas.

A source area is formed on the top surface of each of the plurality of active areas.

A capacitor connected to the source area is formed on the surface of the semiconductor substrate.

The operation that the plurality of metal gates are formed includes the following operations. A metal layer is formed on the surface of the gate dielectric layer and the surface of the first isolation layer. An excess portion of the metal layer is removed through maskless etching, so as to form the plurality of metal gates surrounding the plurality of active areas on the surface of the gate dielectric layer arranged on the side walls of the plurality of active areas.

In some embodiments, a width of the bit line doped area is greater than or equal to a width of the bottom portion of each of the plurality of second trenches.

In some embodiments, the bit line doped area is formed through a first ion implantation process, and impurity ions implanted through the first ion implantation process are N-type impurity ions or P-type impurity ions.

In some embodiments, the method further includes the following operations. Before the first ion implantation process is performed, a protective layer is formed on side walls and bottom surfaces of the plurality of first trenches, side walls and bottom surfaces of the plurality of third trenches, and side walls and bottom surfaces of the plurality of the second trenches. After the protective layer is formed, a mask layer is formed on a surface of the semiconductor substrate, in which the mask layer is provided with a plurality of openings exposing the semiconductor substrate at the bottom portion of each of the plurality of second trenches and at the bottom portion of the communication region of each of the plurality of third trenches with each of the plurality of second trenches. The first ion implantation process is performed on the semiconductor substrate at the bottom portion of each of the plurality of second trenches and at the bottom portion of the communication region of each of the plurality of third trenches with each of the plurality of second trenches along the plurality of openings by using the mask layer as a mask, so as to form the bit line doped area in the semiconductor substrate at the bottom portion of each of the plurality of second trenches and at the bottom portion of the communication region of each of the plurality of third trenches with each of the plurality of second trenches.

**In** some embodiments, the source area is formed through a second ion implantation process.

**In** some embodiments, a type of impurity ions doped in the source area is the same as a type of impurity ions doped in the bit line doped area.

**In** some embodiments, the method further includes the following operations. After the plurality of metal gates are formed, a second isolation layer covering the plurality of metal gates and filling the plurality of first trenches, the plurality of third trenches and the plurality of second trenches is formed. A plurality of conductive connection structures extending along the second direction and configured to connect the plurality of metal gates with each other are formed in the second isolation layer in the plurality of third trenches.

In some embodiments, the operation that the plurality of metal gates are formed includes the following operations. A metal layer filling the plurality of first trenches, the plurality of third trenches and the plurality of second trenches is formed on the surface of the gate dielectric layer and on the surface of the first isolation layer. The metal layer is etched back to allow a top surface of the metal layer to be lower than the top surface of each of the plurality of active areas. After the metal layer is etched back, the metal layer filling the plurality of third trenches is cut along the second direction to form the plurality of metal gates surrounding the plurality of active areas on the surface of the gate dielectric layer arranged on the side walls of the plurality of active areas.

In some embodiments, the operation that the capacitor connected to the source area is formed on the surface of the semiconductor substrate includes the following operations. A first dielectric layer is formed on the semiconductor substrate. A plurality of through holes exposing a surface of the source area are formed in the first dielectric layer. A contact plug is formed in each of the plurality of through holes. A second dielectric layer is formed on the first dielectric layer. A capacitor hole exposing the contact plug is formed in the second dielectric layer. The capacitor is formed in the capacitor hole.

In some embodiments, the plurality of active areas are arranged in rows and columns.

In some embodiments, the operation that the plurality of active areas are formed includes the following operations. A plurality of first mask patterns arranged parallel to each other and extending along the first direction are formed on the semiconductor substrate, in which a plurality of first openings and a plurality of second openings are alternately arranged between any two of the plurality of first mask patterns adj acent to each other, and a width of each of the plurality of first openings is greater than a width of each of the plurality of second openings. A plurality of second mask patterns arranged parallel to each other and extending along the second direction are formed on the plurality of first mask patterns, in which a plurality of sixth openings are provided between any two of the plurality of second mask patterns adj acent to each other. The plurality of first mask patterns are etched along the plurality of sixth openings by using the plurality of second mask patterns as masks, so as to form a plurality of third openings extending along the second direction in the plurality of first mask patterns, in which a remaining portion of the plurality of first mask patterns is formed as a plurality of discrete etching masks. The semiconductor substrate is etched by using the plurality of etching masks as masks, so as to form the plurality of first trenches corresponding to the plurality of first openings, the plurality of second trenches corresponding to the plurality of second openings, and the plurality of third trenches corresponding to the plurality of third openings in the semiconductor substrate, in which a plurality of areas between the plurality of first trenches, the plurality of second openings, and the plurality of third trenches are formed as the plurality of active areas, the plurality of first trenches and the plurality of second trenches communicate with the plurality of third trenches, the depth of each of the plurality of second trenches is less than the depth of each of the plurality of first trenches, and the depth of the region of each of the plurality of third trenches other than the communication region of each of the plurality of third trenches with each of the plurality of second trenches is greater than the depth of each of the plurality of second trenches.

In some embodiments, the plurality of first mask patterns and the plurality of second mask patterns are formed through a self-aligned double patterning process.

In some embodiments, the operation that the plurality of first mask patterns are formed includes the following operations. A first hard mask layer is formed on the semiconductor substrate. A plurality of first strip structures extending along the first direction and arranged parallel to each other are formed on the first hard mask layer. A first sacrificial spacer layer is formed on side walls and top surfaces of the plurality of first strip structures and on a surface of the first hard mask layer between the plurality of first strip structures. A first filling layer is filled between the plurality of first strip structures. The first sacrificial spacer layer on surfaces of the side walls of the plurality of first strip structures is removed, so as to form a plurality of fourth openings between the plurality of first strip structures and the first filling layer. The first hard mask layer is etched along the plurality of fourth openings, so as to form the plurality of first openings in the first hard mask layer. A second filling layer filling the plurality of first openings is formed. A plurality of second strip structures extending along the first direction and arranged parallel to each other are formed on the second filling layer, in which each of the plurality of second strip structures covers the second filling layer in a respective one of the plurality of first openings and a portion of the first hard mask layer on both sides of the respective one of the plurality of first openings. A second sacrificial spacer layer is formed on side walls and top surfaces of the plurality of second strip structures and on surfaces of the first hard mask layer and the first filling layer between the plurality of second strip structures. A third filling layer is filled between the plurality of second strip structures. The second sacrificial spacer layer on surfaces of the side walls of the plurality of second strip structures is removed, so as to form a plurality of fifth openings between the plurality of second strip structures and the second filling layer, in which a width of each of the plurality of fifth openings is less than a width of each of the plurality of fourth openings. The first hard mask layer between the plurality of first openings is etched along the plurality of fifth openings, so as to form the plurality of second openings in the first hard mask layer, in which the width of each of the plurality of second openings is less than the width of each of the plurality of first openings, and a remaining portion of first hard mask layer between the plurality of second openings and the plurality of first openings is formed as the plurality of first mask patterns.

Some other embodiments of the application further provide a storage device, which includes:
a semiconductor substrate, in which a plurality of active areas are formed in the semiconductor substrate, the plurality of active areas are spaced apart from each other by a plurality of first trenches and a plurality of second trenches extending along a first direction and a plurality of third trenches extending along a second direction, the plurality of first trenches and the plurality of second trenches communicate with the plurality of third trenches, the plurality of first trenches and the plurality of second trenches are spaced apart from each other in the second direction, a depth of each of the plurality of second trenches is less than a depth of each of the plurality of first trenches, and a depth of a region of each of the plurality of third trenches other than a communication region of each of the plurality of third trenches with each of the plurality of second trenches is greater than the depth of each of the plurality of second trenches;
a bit line doped area arranged in the semiconductor substrate at a bottom portion of each of the plurality of second trenches and at a bottom portion of the communication region of each of the plurality of third trenches with each of the plurality of second trenches;
a first isolation layer arranged in each of the plurality of first trenches and each of the plurality of third trenches, in which a surface of the first isolation layer is lower than a surface of each of the plurality of active areas;
a gate dielectric layer arranged on the surfaces of the plurality of active areas and surrounding the plurality of active areas;
a plurality of metal gates arranged on a surface of the gate dielectric layer on side walls of the plurality of active areas and surrounding the plurality of active areas, in which a top surface of each of the plurality of metal gates is lower than a top surface of each of the plurality of active areas; and
a source area arranged on the top surface of each of the plurality of active areas.

The plurality of first trenches, the plurality of third trenches, and the plurality of second trenches are completely filled with the plurality of metal gates, each of the plurality of metal gates is lower than the top surface of each of the plurality of active areas, and a portion of the plurality of metal gates in the plurality of third trenches is cut along the second direction.

The storage device further includes a capacitor arranged on the semiconductor substrate and connected to the source area.

In some embodiments, a width of the bit line doped area is greater than or equal to a width of the bottom portion of each of the plurality of second trenches.

In some embodiments, impurity ions doped in the bit line doped area are N-type impurity ions or P-type impurity ions.

In some embodiments, a type of impurity ions doped in the source area is the same as a type of impurity ions doped in the bit line areas.

In some embodiments, the plurality of metal gates are arranged on the surface of the gate dielectric layer on the side walls of the plurality of active areas and surround the plurality of active areas, and each of the plurality of first trenches, each of the plurality of third trenches, and each of the plurality of second trenches are partially filled with the plurality of metal gates.

In some embodiments, the storage device further includes: a second isolation layer covering the plurality of metal gates and filling the plurality of first trenches, the plurality of third trenches, and plurality of the second trenches; and a plurality of conductive connection structures arranged in the second isolation layer in the plurality of third trenches, extending along the second direction, and configured to connect the plurality of metal gates with each other.

According to the method for forming the storage device provided in some above embodiments of the application, a semiconductor substrate is provided, and a plurality of active areas are formed in the semiconductor substrate, in which the plurality of active areas are spaced apart from each other by a plurality of first trenches and a plurality of second trenches extending along a first direction and a plurality of third trenches extending along a second direction, the plurality of first trenches and the plurality of second trenches communicate with the plurality of third trenches, the plurality of first trenches and the plurality of second trenches are spaced apart from each other in the second direction, a depth of each of the plurality of second trenches is less than a depth of each of the plurality of first trenches, and a depth of a region of each of the plurality of third trenches other than a communication region of each of the plurality of third trenches with each of the plurality of second trenches is greater than the depth of each of the plurality of second trenches; a bit line doped area is formed in the semiconductor substrate at a bottom portion of each of the plurality of second trenches and at a bottom portion of the communication region of each of the plurality of third trenches with each of the plurality of second trenches; a first isolation layer is formed in each of the plurality of first trenches and each of the plurality of third trenches, in which a surface of the first isolation layer is lower than a surface of each of the plurality of active areas; a gate dielectric layer surrounding the plurality of active areas is formed on the surfaces of the plurality of active areas; a plurality of metal gates surrounding the plurality of active areas are formed on a surface of the gate dielectric layer arranged on side walls of the plurality of active areas, in which a top surface of each of the plurality of metal gates is lower than a top surface of each of the plurality of active areas; and a source area is formed on the top surface of each of the plurality of active areas. A plurality of vertical transistors are formed through the above method. Each vertical transistor includes a respective active area, a gate dielectric layer arranged on the surfaces of the side wall of the active area, a bit line doped area arranged in the semiconductor substrate at the bottom portion of the second trench, a source area arranged on the top surface of the active area, and a metal gate arranged on the surface of the gate dielectric layer on the side wall of the first trench, the second trench, and the third trench and surrounding the active area. In the vertical transistor of the specific structure described above, since the source area and the drain area are arranged on the upper and lower sides of the active area, the formed channel area is arranged on the side wall of the active area, so that an area of the semiconductor substrate occupied by the vertical transistor is relatively small, the number of the vertical transistors formed in the unit area can be increased, and the number of the capacitors that are subsequently formed in the unit area and connected to the source area of each transistor can also be increased accordingly, thereby improving the storage capacity and the storage density of the memory. In addition, the vertical transistor of such a specific structure can reduce the body effect, and reduce the leakage current generated by the subsequently formed capacitor into the substrate, thereby improving the electrical performance of the storage device.

### BRIEF DESCRIPTION OF THE DRAWINGS

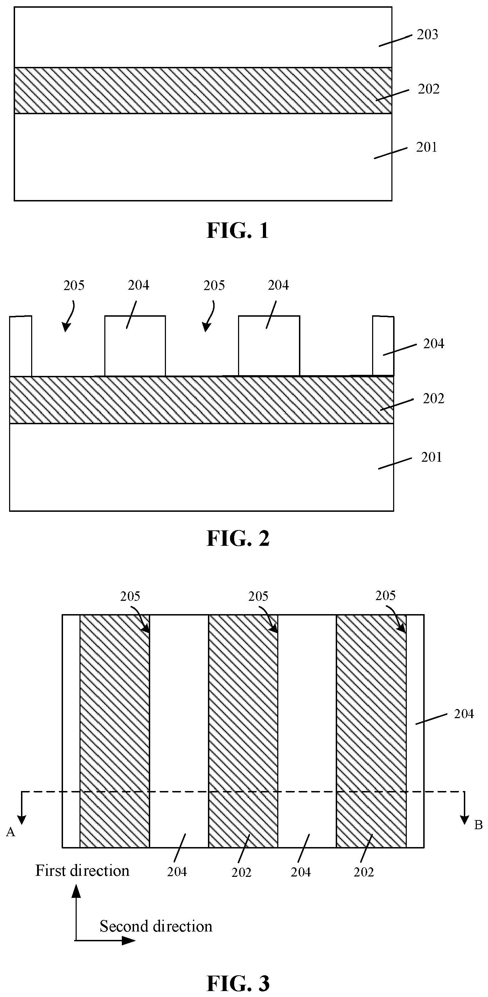

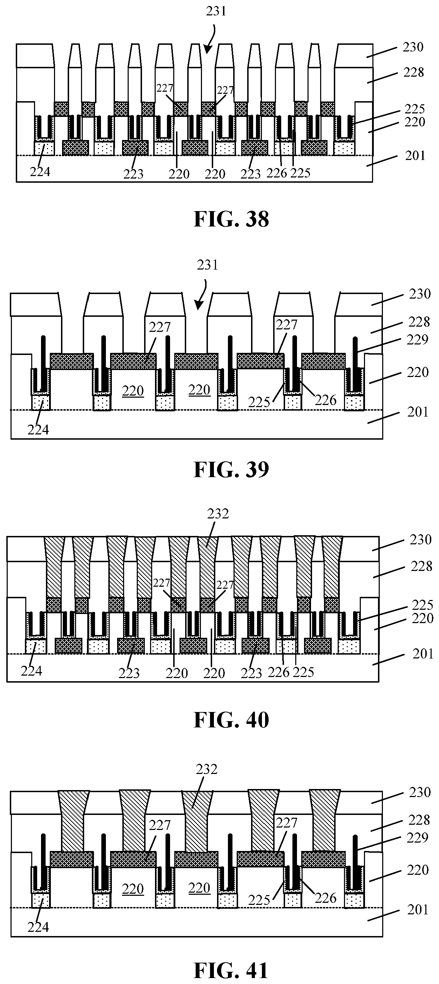

FIG. 1 to FIG. 43 are schematic diagrams of a formation process of a storage device according to some embodiments of the application.

### DETAILED DESCRIPTION

As mentioned in the background, it is an urgent problem to be solved by those skilled in the art how to further improve the storage capacity and the storage density of the DRAM.

It has been found through researches that a trench-type transistor generally includes at least one buried word line in a semiconductor substrate and a drain area and at least one source area in the semiconductor substrate on both sides of the buried word line. Such a trench-type transistor occupies a relatively large area of the semiconductor substrate, which is not conducive to the improvement of the integration of the DRAM, so that the storage capacity and the storage density of the DRAM are limited.

For this purpose, the application provides a new storage device and a method for forming a storage device, so that the storage capacity and the storage density of the storage device can be further improved.

In order to make the foregoing objectives, features, and advantages of the application more apparent and lucid, various embodiments of the application are described in detail below with reference to the accompanying drawings. When the embodiments of the application are described in detail, for the convenience of description, a schematic diagram may be partially enlarged not according to a general scale, and the schematic diagram is only an example, and should not limit the protection scope of the application herein. In addition, three-dimensional dimensions (length, width and depth) should be included in actual production.

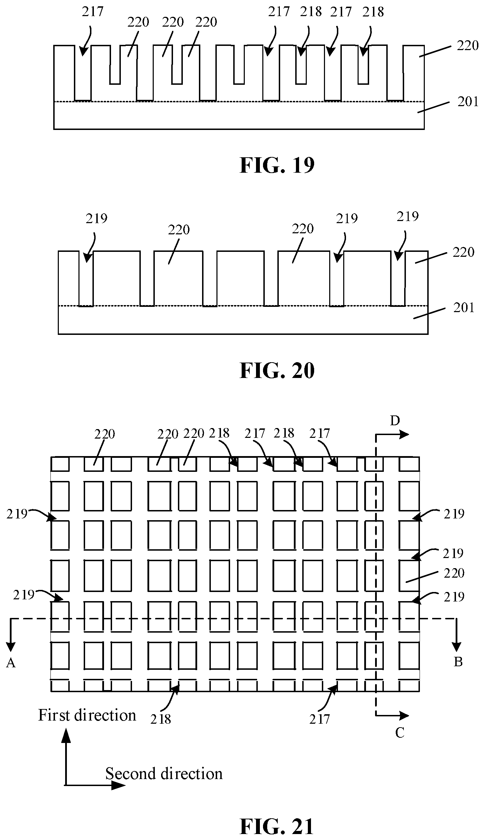

With reference to FIG. 19 to FIG. 21, FIG. 19 is a schematic cross-sectional view taken along a cutting line AB shown in FIG. 21, and FIG. 20 is a schematic cross-sectional view taken along a cutting line CD shown in FIG. 21. A semiconductor substrate 201 is provided, and a plurality of active areas 220 are formed in the semiconductor substrate 201. The plurality of active areas 220 are spaced apart from each other by a plurality of first trenches 217 and a plurality of second trenches 218 extending along a first direction and a plurality of third trenches 219 extending along a second direction. The plurality of first trenches 217 and the plurality of second trenches 218 communicate with the plurality of third trenches 219, and the plurality of first trenches 217 and the plurality of second trenches 218 are spaced apart from each other in the second direction. A depth of each of the plurality of second trenches 218 is less than a depth of each of the plurality of first trenches 217, and a depth of a region of each of the plurality of third trenches 219 other than a communication region of each of the plurality of third trenches with each of the plurality of second trenches 218 is greater than the depth of each of the plurality of second trenches 218.

The material of the semiconductor substrate 201 may be silicon (Si), germanium (Ge), silicon germanium (GeSi), or silicon carbide (SiC); may also be silicon-on-insulator, SOI, or germanium-on-insulator, GOI; or may also be other materials, for example, III-V group compounds such as gallium arsenide. In this embodiment, the material of the semiconductor substrate 201 is silicon. The semiconductor substrate 201 needs to be doped with certain impurity ions according to the type of the vertical transistor to be formed subsequently. For example, well area doping may be performed on the semiconductor substrate. The impurity ions may be N-type impurity ions or P-type impurity ions. The P-type impurity ions are one or more of boron ions, gallium ions or indium ions, and the N-type impurity ions are one or more of phosphorus ions, arsenic ions or antimony ions.

The active area 220 is configured to subsequently form a channel area, a source area, and a drain area of the vertical transistor, and the plurality of active areas 220 are discrete.

In some embodiments, the formed active areas 220 are arranged in rows and columns (with reference to FIG. 21). In other embodiments, the active areas may also be arranged in other manners.

In some embodiments, the first direction and the second direction are perpendicular to each other, and an angle between the first direction and the second direction is 90 degrees. In other embodiments, the first direction may not be perpendicular to the second direction. For example, the angle between the first direction and the second direction may be an acute angle.

In some embodiments, the plurality of second trenches 218 and the plurality of first trenches 217 extend along the first direction and are alternately distributed in the semiconductor substrate 201. The plurality of third trenches 219 extend along the second direction. The plurality of third trenches 219 communicate with the plurality of first trenches 217 and the plurality of second trenches 218 at intersections. The depth of each second trench 218 is less than the depth of each first trench 217. The depths of the communication regions of the third trenches 219 with the second trenches 218 are the same or have a small difference therebetween, and the depth of the region of each third trench 219 other than the communication region of each third trench 219 with each second trench 218 is greater than the depth of each second trench 218.

In some embodiments, a width of each first trench 217 may be greater than a width of each second trench 218.

In some embodiments, the semiconductor substrate 201 may be etched firstly, so as to form the plurality of first trenches 217 and the plurality of second trenches 218 extending along the first direction and spaced apart from each other. The depth of each formed first trench 217 is greater than the depth of each formed second trench. Then, the semiconductor substrate 201 is etched to form a plurality of third trenches 219 extending along the second direction, so as to form a plurality of discrete active areas 220. The depths of the communication regions of the third trenches 219 with the second trenches 218 are the same or have a small difference therebetween, and the depth of the region of each third trench 219 other than the communication region of each third trench 219 with each second trench 218 is greater than the depth of each second trench 218 (when the third trenches 219 are formed, a mask layer is firstly formed on the semiconductor substrate 201, and the positions at which the second trenches 218 and the first trenches 217 have been formed may be covered by the mask layer and may not be etched, the mask layer may only expose a surface of the semiconductor substrate between the first trenches and the second trenches that needs to be etched). In some embodiments, the semiconductor substrate 201 may be etched firstly to form a plurality of first trenches 217, and then the semiconductor substrate is etched to form a plurality of second trenches 218. The depth of each second trench 218 is less than the depth of each first trench 217. Finally the semiconductor substrate 201 is etched to form a plurality of third trenches 219, so as to form a plurality of discrete active areas 220. The depths of the communication regions of the third trenches 219 with the second trenches 218 are the same or have a small difference therebetween, and the depth of the region of each third trench 219 other than the communication region of each third trench 219 with each second trench 218 is greater than the depth of each second trench 218. In other embodiments, the first trenches 217, the second trenches 218, and the third trenches 219 may also be simultaneously formed by etching the semiconductor substrate 201.

In this embodiment, the plurality of active areas 220 are formed through a self-aligned double patterning mask process. The formation process of the active areas 220 is described in detail with reference to FIG. 1 to FIG. 21.

With reference to FIG. 1, a first hard mask layer 202 is formed on the semiconductor substrate 201; and a first material layer 203 is formed on the first hard mask layer 202.

The first hard mask layer 202 is configured to subsequently form a plurality of first mask patterns. In some embodiments, the first hard mask layer 202 may have a single-layer structure or a multi-layer stack structure, and the material of the first hard mask layer 202 may be one or more of polysilicon, amorphous silicon, amorphous carbon, silicon nitride, silicon oxynitride, silicon oxide, silicon nitride carbide, silicon oxycarbide, silicon carbide, and silicon germanium. The formation process of the first hard mask layer 202 may be an atmospheric or low pressure chemical vapor deposition, CVD, process, a plasma enhanced chemical vapor deposition, PECVD, process, a thermal chemical vapor deposition, Thermal CVD, process, a physical vapor deposition, PVD, process, an atomic layer deposition, ALD, process, a sputtering process, a plating process, an electroplating process, a spin coating process or other suitable processes, and/or a combination thereof. In this embodiment, the material of the first hard mask layer 202 is polysilicon.

In some embodiments, a first etch stop layer (not shown in the figure) may also be formed between the first hard mask layer 202 and the semiconductor substrate 201. The first etch stop layer is configured to protect the material layer below the first etch stop layer from being over-etched when the first hard mask layer is patterned. The material of the first etch stop layer is different from the material of the first hard mask layer, and the material of the first etch stop layer is one or more of silicon nitride, silicon oxynitride, silicon oxide, silicon nitride carbide, and silicon oxycarbide. In this embodiment, the material of the first etch stop layer is silicon oxide.

The first material layer 203 is configured to subsequently form a plurality of first strip structures. In some embodiments, the first material layer 203 may have a single-layer structure or a multi-layer stack structure, and the material of the first material layer 203 may be one or more of polysilicon, amorphous silicon, amorphous carbon, silicon nitride, silicon oxynitride, silicon oxide, silicon nitride carbide, silicon oxycarbide, silicon carbide, and silicon germanium. In this embodiment, the material of the first material layer 203 is amorphous carbon.

In some embodiments, a second etch stop layer (not shown in the figure) may also be formed between the first material layer 203 and the first hard mask layer 202. The second etch stop layer is configured to protect the material layer below the second etch stop layer from being over-etched when the first material layer 203 is patterned. The material of the second etch stop layer is different from the material of the first material layer 203. The material of the second etch stop layer is one or more of silicon nitride, silicon oxynitride, silicon oxide, silicon nitride carbide, and silicon oxycarbide. In this embodiment, the material of the second etch stop layer is silicon oxynitride.

With reference to FIG. 2 and FIG. 3, FIG. 2 is a schematic cross-sectional view taken along a cutting line AB shown in FIG. 3. The first material layer 203 (with reference to FIG. 1) is patterned, so as to form a plurality of first strip structures 204 extending along the first direction and arranged parallel to each other on the first hard mask layer 202.

Each first strip structure 204 is in the shape of a strip. The plurality of first strip structures 204 are discrete and parallel to each other. An opening 205 is provided between any two of the first strip structures 204 adjacent to each other.

In some embodiments, the first material layer 203 is patterned through an anisotropic dry etching process, in particular an anisotropic plasma etching process.

In some embodiments, before the first material layer 203 is patterned, a patterned photoresist layer (not shown in the figure) may also be formed on the first material layer 203. The first material layer 203 is etched by using the patterned photoresist layer as a mask, so as to form the plurality of first strip structures 204. The patterned photoresist layer is removed.

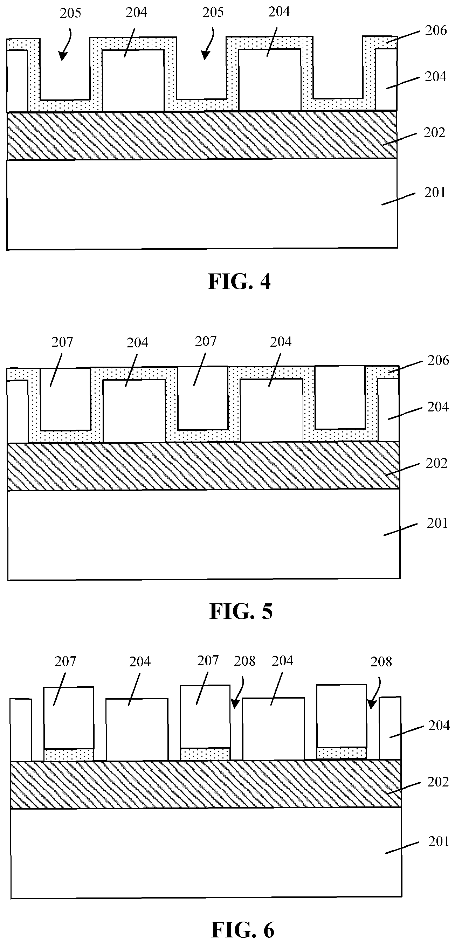

With reference to FIG. 4, a first sacrificial spacer layer 206 is formed on side walls and top surfaces of the plurality of first strip structures 204 and on a surface of the first hard mask layer 202 between the plurality of first strip structures 204.

The material of the first sacrificial spacer layer 206 is different from the material of the first strip structure 204, and the material of the first sacrificial spacer layer 206 may be one or more of polysilicon, amorphous silicon, amorphous carbon, silicon nitride, silicon oxynitride, silicon oxide, silicon nitride carbide, silicon oxycarbide, silicon carbide, and silicon germanium. The first sacrificial spacer layer 206 is formed through a deposition process, which includes an atomic layer deposition process.

With reference to FIG. 5, a first filling layer 207 is filled between the plurality of first strip structures 204.

The first filling layer 207 is arranged on the surface of the first sacrificial spacer layer 206 between the first strip structures 204 and fills the openings between the first strip structures 204.

Subsequently, by removing the first sacrificial spacer layer 206 on surfaces of the side walls of the first strip structures 204, a plurality of fourth openings are formed between the first strip structures 204 and the first filling layer 207.

The material of the first filling layer 207 is different from the material of the first sacrificial spacer layer 206. In some embodiments, the material of the first filling layer 207 may be one or more of polysilicon, amorphous silicon, amorphous carbon, silicon nitride, silicon oxynitride, silicon oxide, silicon nitride carbide, silicon oxycarbide, silicon carbide, silicon germanium, and organic materials. The formation process of the first filling layer 207 may be an atmospheric or low pressure chemical vapor deposition, CVD, process, a plasma enhanced chemical vapor deposition, PECVD, process, a thermal chemical vapor deposition, Thermal CVD, process, a physical vapor deposition, PVD, process, an atomic layer deposition, ALD, process, a sputtering process, a plating process, an electroplating process, a spin coating process or other suitable processes, and/or a combination thereof.

In some embodiments, the surface of the formed first filling layer 207 may be flush with the first sacrificial spacer layer 206 on the top surfaces of the first strip structures 204. Specifically, after a first filling material layer covering the first sacrificial spacer layer 206 and filling the remaining openings between the first strip structures 204 is formed, the first filling layer above the surface of the first sacrificial spacer layer 206 on the top surfaces of the first strip structures 204 is remove through a chemical mechanical mask process, so that the first filling material layer remaining in the openings is formed as the first filling layer 207.

In some embodiments, the surface of the formed first filling layer may be flush with the top surfaces of the first strip structures 204. Specifically, after a first filling material layer covering the first sacrificial spacer layer 206 and filling the remaining openings between the first strip structures 204 is formed, the first sacrificial spacer layer 206 and the first filling material layer above the top surfaces of the first strip structures 204 are removed through the chemical mechanical mask process, so as to expose the top surfaces of the first strip structures 204, and the first filling material layer remaining in the openings is formed as the first filling layer. Therefore, the top surface of the formed first filling layer is flush with the top surfaces of the first strip structures. Subsequently, after the third openings are formed, when the first hard mask layer is etched, the etching load effect caused by the height difference between the filling layer and the first strip structures can be reduced, the accuracy of the position and the dimension of the formed first mask patterns can be improved, and a better side wall profile can be maintained, so that the accuracy of the position and the dimension of the block mask patterns formed after the first mask patterns are disconnected from each other is relatively high, and a better side wall profile is maintained, thereby allowing the accuracy of the position and the dimension of the active areas formed by etching the semiconductor substrate by using the block mask patterns as masks to be relatively high, and maintaining a better side wall profile.

With reference to FIG. 6, the first sacrificial spacer layer on the surfaces of the side walls of the first strip structures 204 is removed, so as to form a plurality of fourth openings 208 between the first strip structures 204 and the first filling layer 207.

In some embodiments, the first sacrificial spacer layer on the surfaces of the side walls of the first strip structures 204 is removed through an anisotropic dry etching process, which includes an anisotropic plasma etching process.

It should be noted that, in some embodiments, when the first sacrificial spacer layer on the surfaces of the side walls of the first strip structures 204 is removed, the first sacrificial spacer layer on the top surfaces of the first strip structures 204 is also removed.

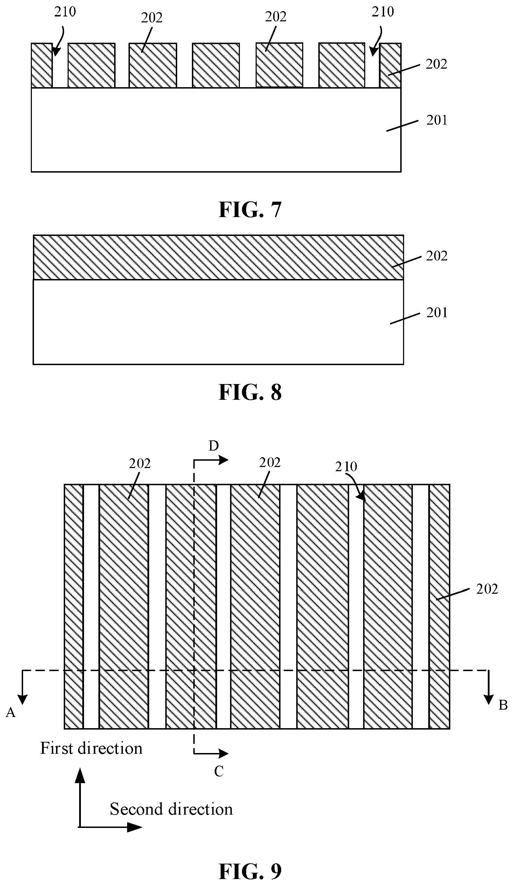

With reference to FIG. 7 to FIG. 9, FIG. 7 is a schematic cross-sectional view taken along a cutting line AB shown in FIG. 9, and FIG. 8 is a schematic cross-sectional view taken along a cutting line CD shown in FIG. 9. The first hard mask layer 202 is etched along the plurality of fourth openings, so as to form a plurality of first openings 210 extending along the first direction in the first hard mask layer 202.

In some embodiments, the first hard mask layer 202 is etched through an anisotropic dry etching process, which includes an anisotropic plasma etching process.

The first openings 210 described in the application are formed through the above-mentioned self-aligned double patterning process. When the active areas are subsequently formed, the width of each of the first trenches which are arranged between the active areas and correspond to the first openings may be smaller, so that the areas of the active areas may be larger.

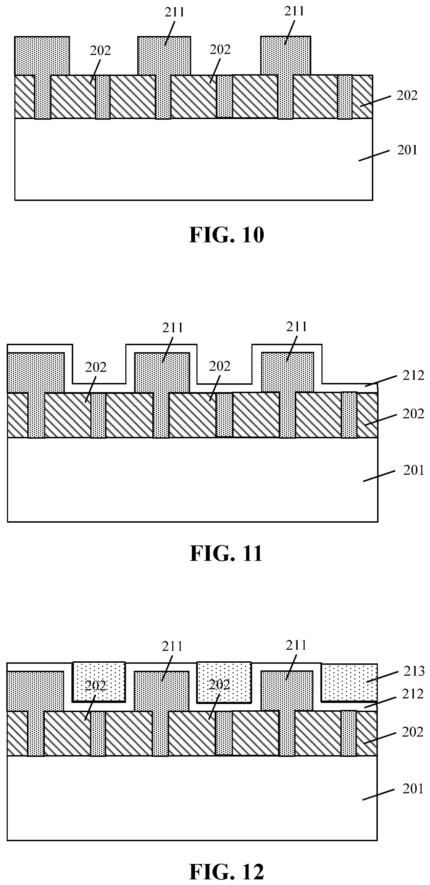

With reference to FIG. 10, the operation shown in FIG. 10 is performed on the basis of the operation shown in FIG. 7, in which a second filling layer filling the plurality of first openings is formed, and a plurality of second strip structures 211 extending along the first direction and arranged parallel to each other are formed on the second filling layer. Each of the plurality of second strip structures 211 covers the second filling layer in a respective one of the plurality of first openings and a portion of the first hard mask layer 202 on both sides of the respective one of the plurality of first openings, and a second filling layer filled in one of the openings is exposed between two adjacent second strip structures 211.

In some embodiments, the second filling layer and the second strip structures 211 are formed in the same operation, which specifically includes the following operations. A second material layer is formed on the surface of the first hard mask layer 202, in which the second material layer fills the first openings. A portion of the second material layer is removed by etching, so as to form a plurality of second strip structures 211 and the second filling layer filling the first openings.

The materials of the second filling layer and the second strip structures 211 are different from the material of the first hard mask layer 202. In some embodiments, the materials of the second filling layer and the second strip structures 211 may be one or more of polysilicon, amorphous silicon, amorphous carbon, silicon nitride, silicon oxynitride, silicon oxide, silicon nitride carbide, silicon oxycarbide, silicon carbide, silicon germanium, and the organic materials.

With reference to FIG. 11, a second sacrificial spacer layer 212 is formed on side walls and top surfaces of the plurality of second strip structures 211 and on the surfaces of the first hard mask layer 202 and the first filling layer between the plurality of second strip structures 211.

The material of the second sacrificial spacer layer 212 is different from the material of each second strip structure 211. In some embodiments, the material of the second sacrificial spacer layer 212 may be one or more of polysilicon, amorphous silicon, amorphous carbon, silicon nitride, silicon oxynitride, silicon oxide, silicon nitride carbide, silicon oxycarbide, silicon carbide, and silicon germanium. The second sacrificial spacer layer 212 is formed through a deposition process, which includes an atomic layer deposition process.

With reference to FIG. 12, a third filling layer 213 is filled between the plurality of second strip structures 211.

The third filling layer 213 is arranged on the second sacrificial spacer layer 212 between the second strip structures 211 and fills the spaces between the second strip structures 211.

Subsequently, the second sacrificial spacer layer on surfaces of the side walls of the plurality of second strip structures 204 is removed, so as to form a plurality of fifth openings between the plurality of second strip structures 211 and the third filling layer 213.

The material of the third filling layer 213 is different from the material of the second sacrificial spacer layer 212. In some embodiments, the material of the third filling layer 213 may be one or more of polysilicon, amorphous silicon, amorphous carbon, silicon nitride, silicon oxynitride, silicon oxide, silicon nitride carbide, silicon oxycarbide, silicon carbide, silicon germanium, and the organic materials. The formation process of the third filling layer 213 may be an atmospheric or low pressure chemical vapor deposition, CVD, process, a plasma enhanced chemical vapor deposition, PECVD, process, a thermal chemical vapor deposition, Thermal CVD, process, a physical vapor deposition, PVD, process, an atomic layer deposition, ALD, process, a spurting process, a plating process, an electroplating process, a spin coating process or other suitable processes, and/or a combination thereof.

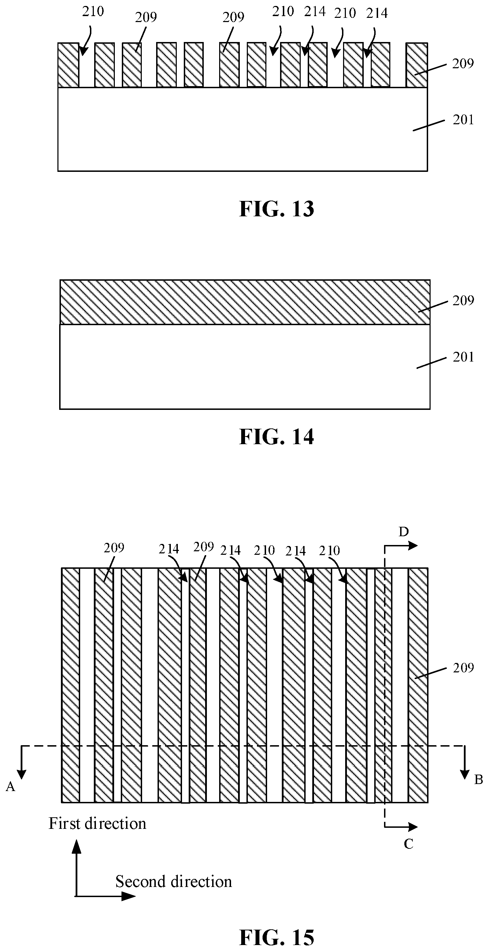

With reference to FIG. 13 to FIG. 15, FIG. 13 is a schematic cross-sectional view taken along a cutting line AB shown in FIG. 15, and FIG. 14 is a schematic cross-sectional view taken along a cutting line CD shown in FIG. 15. The second sacrificial spacer layer 212 (with reference to FIG. 12) on surfaces of the side walls of the plurality of second strip structures 211 is removed, so as to form a plurality of fifth openings between the plurality of second strip structures 211 and the second filling layer 213, in which a width of each of the plurality of fifth openings is less than a width of each of the plurality of fourth openings. The first hard mask layer between the plurality of first openings 210 is etched along the plurality of fifth openings, so as to form the plurality of second openings 214 in the first hard mask layer, in which the width of each of the plurality of second openings 214 is less than the width of each of the plurality of first openings 210, the plurality of second openings 214 and the plurality of first openings 210 are alternately distributed, and a remaining portion of the first hard mask layer between the plurality of second openings 214 and the plurality of first openings 210 is formed as the plurality of first mask patterns 209.

In some embodiments, the first hard mask layer 202 is etched through an anisotropic dry etching process, which includes an anisotropic plasma etching process.

The plurality of formed first mask patterns 209 are discrete. Specifically, the formed first mask patterns 209 extend along the first direction and are arranged parallel to each other, and first openings 210 and second openings 214 are alternately distributed between the adjacent first mask patterns 209.

A width of each formed second opening 214 is less than a width of each first opening 210. Subsequently, when the semiconductor substrate 201 is etched in the same etching process, the etching rate of the semiconductor substrate at the bottom portions of the second openings 214 is higher than the etching rate of the semiconductor substrate at the bottom portions of the first openings, so that the depth of each second trench correspondingly formed in the semiconductor substrate 201 is less than the depth of each first trench, thereby simplifying the formation processes of the first trenches and the second trenches, while allowing the dimensions of the formed first trenches and the formed second trenches to be smaller.

The first mask patterns 209 described above in the application are formed through the above-mentioned self-aligned double patterning process. When the active areas are subsequently formed, the width of each first trench between the active areas and the width of each second trench between the active areas may be smaller, so that the areas of the active areas may be larger.

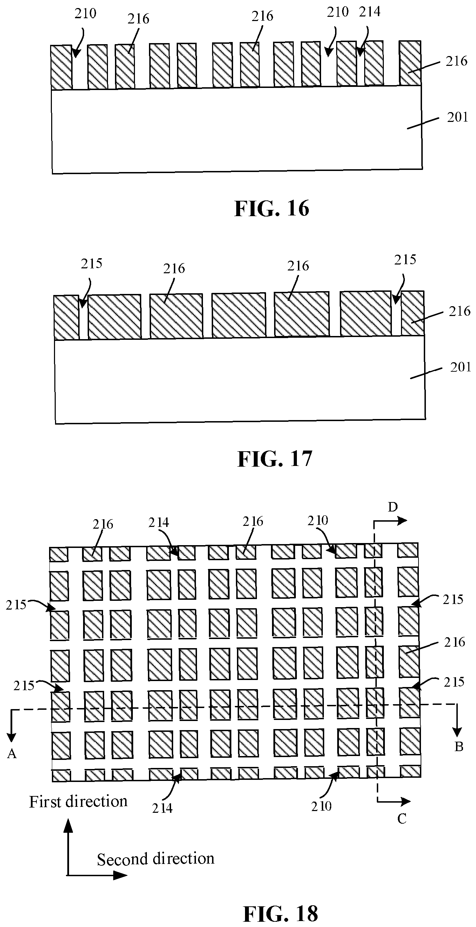

After the plurality of first mask patterns 209 arranged parallel to each other and extending along the first direction are formed on the semiconductor substrate 201, in which a plurality of first openings 210 and a plurality of second openings 214 are alternately distributed between any two of the plurality of first mask patterns 209 adjacent to each other, and a width of each of the plurality of first opening 210 is greater than a width of each of the plurality of second opening 214, the method further includes the following operations. A plurality of second mask patterns arranged parallel to each other and extending along the second direction are formed on the plurality of first mask patterns 209, in which a plurality of sixth openings are provided between any two of the plurality of second mask patterns adjacent to each other, and the second mask patterns are also formed through the self-aligned double patterning process. The plurality of first mask patterns are etched along the plurality of sixth openings by using the plurality of second mask patterns as masks, so as to form a plurality of third openings 215 extending along the second direction in the plurality of first mask patterns, in which a remaining portion of the plurality of first mask patterns is formed as a plurality of discrete etching masks 216 (with reference to FIG. 16 to FIG. 18, FIG. 16 is a schematic cross-sectional view taken along a cutting line AB shown in FIG. 18, and FIG. 17 is a schematic cross-sectional view taken along a cutting line CD shown in FIG. 18).

With reference to FIG. 19 to FIG. 21, the semiconductor substrate 201 is etched by using the plurality of etching masks as masks, so as to form the plurality of first trenches 217 corresponding to the plurality of first openings, the plurality of second trenches 218 corresponding to the plurality of second openings, and the plurality of third trenches 219 corresponding to the plurality of third openings in the semiconductor substrate 201. A plurality of areas between the plurality of first trenches 217, the plurality of second openings 218, and plurality of the third trenches 219 are formed as the plurality of active areas 220. The plurality of first trenches 217 and the plurality of second trenches 218 communicate with the plurality of third trenches 219. The depth of each of the plurality of second trenches 218 is less than the depth of each of the plurality of first trenches 217, and the depth of the region of each of the plurality of third trenches 219 other than the communication region of each of the plurality of third trenches 219 with each of the plurality of second trenches 218 is greater than the depth of each of the plurality of second trenches 218.

The semiconductor substrate 201 is etched through an anisotropic dry etching process, which includes an anisotropic plasma etching process.

The etching masks may be removed simultaneously during etching of the semiconductor substrate, or may be removed through an additional etching process after the active areas are formed.

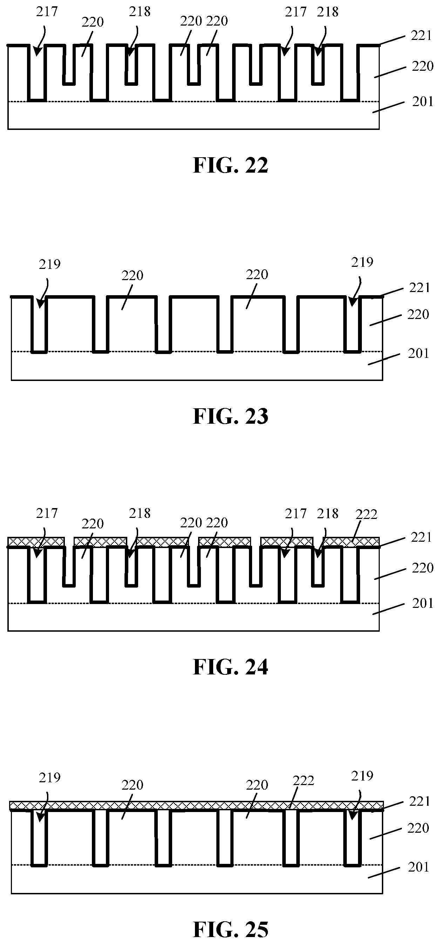

With reference to FIG. 22 and FIG. 23, the operation shown in FIG. 22 is performed on the basis of the operation shown in FIG. 19, and the operation shown in FIG. 23 is performed on the basis of the operation shown in FIG. 20, in which a protective layer 221 is formed on side walls and bottom surfaces of the plurality of first trenches 217, side walls and bottom surfaces of the plurality of third trenches 219, and side walls and bottom surfaces of the plurality of second trenches 218.

The protective layer 221 protects the surfaces of the side walls of the active areas 220 during subsequent ion implantation.

In some embodiments, the material of the protective layer 221 may be silicon oxide. The protective layer 221 is formed through an oxidation process, which may specifically be furnace oxidation.

With reference to FIG. 24 and FIG. 25, after the protective layer 221 are formed, a mask layer 222 is formed on the surface of the semiconductor substrate 201, in which the mask layer 222 is provided with a plurality of openings exposing the semiconductor substrate 201 at the bottom portion of each of the plurality of second trenches 218 and at the bottom portion of the communication region of each of the plurality of third trenches 219 with each of the plurality of second trenches 218.

The mask layer 222 may have a single-layer structure or a multi-layer stack structure (for example, a double-layer stack structure). In some embodiments, the mask layer 222 may include a hard mask material layer and a photoresist layer arranged on the surface of the hard mask material layer. The material of the hard mask material layer may be one or more of silicon nitride, silicon oxynitride, silicon oxide, silicon nitride carbide, and silicon oxycarbide.

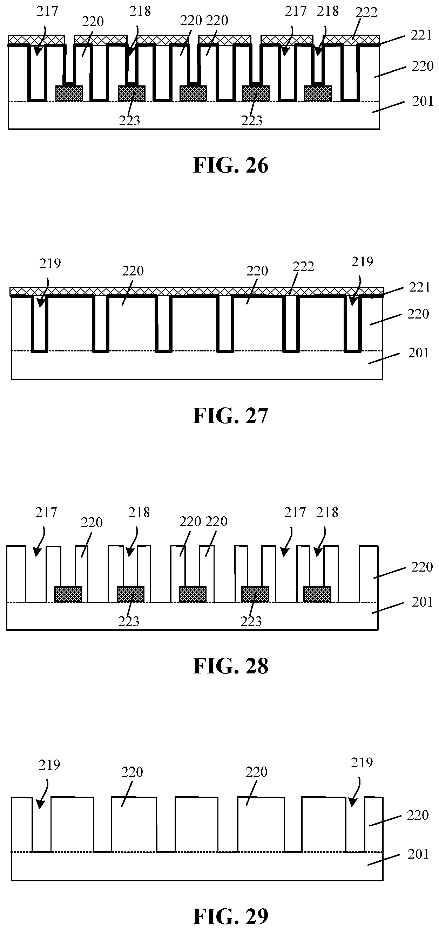

With reference to FIG. 26 and FIG. 27, the first ion implantation process is performed on the semiconductor substrate 201 at the bottom portions of the plurality of second trenches 218 and at the bottom portions of the communication regions of the plurality of third trenches 219 with the plurality of second trenches 218 along the plurality of openings by using the mask layer 222 as a mask, so as to form bit line areas 223 in the semiconductor substrate 201 at the bottom portions of the plurality of second trenches 218 and at the bottom portions of the communication regions of the plurality of third trenches 219 with the plurality of second trenches 218.

The bit line areas 223 are formed through the first ion implantation, and the type of impurity ions implanted into the bit line areas 223 is different from the type of impurity ions implanted into well area of the active areas 220. For example, when P-type impurity ions are implanted into the well area of the active areas 220, N-type impurity ions are implanted into the bit line areas 217; and when N-type impurity ions are implanted into the well area of the active areas 220, P-type impurity ions are implanted into the bit line areas 217. The impurity ions implanted into the bit line areas 217 are N-type impurity ions or P-type impurity ions. The P-type impurity ions are one or more of boron ions, gallium ions or indium ions, and the N-type impurity ions are one or more of phosphorus ions, arsenic ions or antimony ions.

In some embodiments, after the first ion implantation is performed, it is necessary to perform an annealing process to activate the doped ions.

In some embodiments, the width of the formed bit line doped area 223 is greater than or equal to the width of the bottom portion of each of the plurality of second trenches 218, and the bottom portion of the bit line doped area 223 is flush with the bottom portion of each first trench 217 or higher than the bottom portion of each first trench 217 (the bottom portion of the bit line doped area 223 is closer to the surface of the active area 220 than the bottom portion of each first trench 217).

The portion of the bit line doped area 223 in contact with the active area 220 is formed as a drain area of the vertical transistor. There are two active areas 220 between two adjacent first openings 218. The vertical transistor formed in these two active areas 220 share one drain area, so as to improve the integration of the device. In addition, each bit line doped area 223 electrically connects the drain areas in each two adjacent rows of vertical transistors with each other along the first direction, so as to improve the control capability of the vertical transistors, thereby improving the operational capabilities (reading, writing, and deleting) of the subsequently formed memory.

In some embodiments, with reference to FIG. 28 and FIG. 29, after the bit line areas 223 are formed, the protective layer 221 and the mask layer 222 are removed.

The protective layer 221 and the mask layer 222 are removed through a wet etching process.

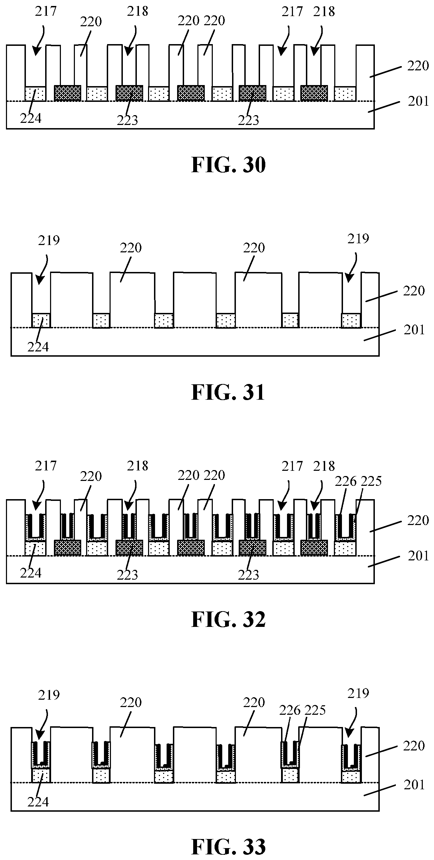

With reference to FIG. 30 and FIG. 31, a first isolation layer 224 is formed in each of the plurality of first trenches 217 and each of the plurality of third trenches 219, in which a surface of the first isolation layer 224 is lower than the surface of each of the plurality of active areas 220.

The first isolation layer 224 is configured for creating electrical isolation between the adjacent active areas and between the adjacent bit line areas 223. In some embodiments, the material of the first isolation layer 224 is silicon oxide, silicon nitride, silicon oxynitride, fluorine-doped silicon glass, FSG, low dielectric constant (where K is less than 2.8) materials, or other suitable materials, and/or a combination thereof.

In some embodiments, the formation process of the first isolation layer 224 includes the following operations. A first isolation material layer is formed on the surfaces of the active areas 220 and in the first trenches 217, the second trenches 218, and the third trenches 219 through a deposition process. A portion of the first isolation material layer is etched back, so as to form the first isolation layer 224 in the first trenches 217 and the third trenches 219.

With reference to FIG. 32 and FIG. 33, a gate dielectric layer 225 surrounding the plurality of active areas 220 is formed on the surfaces of the plurality of active areas 220; and a plurality of metal gates 226 surrounding the plurality of active areas 220 are formed on a surface of the gate dielectric layer 225 arranged on side walls of the plurality of active areas 220, in which a top surface of each of the plurality of metal gates 226 is lower than a top surface of each of the plurality of active areas 220.

The material of the gate dielectric layer 225 may be silicon oxide or a high-K (dielectric constant) dielectric material. The high-K dielectric material is one or more of HfO₂, TiO₂, HfZrO, HfSiNO, Ta₂O₅, ZrO₂, ZrSiO₂, Al₂O₃, SrTiO₃, or BaSrTiO.

The gate dielectric layer 225 may be formed through an oxidation or deposition process.

In some embodiments, the gate dielectric layer 225 may be formed after the protective layer 236 is removed. In another embodiment, the gate dielectric layer may be directly formed on the protective layer 236 without removing the protective layer 236.

In some embodiments, when the gate dielectric layer 225 is formed, the gate dielectric layer 225 may also be formed on the bottom surfaces of the first trenches, the second trenches and the third trenches, and on the top surfaces of the active areas.

The formed metal gate 226 surrounds the side wall of each active area, and the top surface of the metal gate 226 is lower than the top surfaces of the active areas 220, so that the control capability of the metal gates 220 for controlling the formation of channels in the side walls of the active areas can be improved, and the performance of forming the vertical transistors can be improved.

In some embodiments, the material of the metal gate 226 may be one or more of W, Al, Cu, Ag, Au, Pt, Ni, Ti, TiN, TaN, Ta, TaC, TaSiN, WN, and Wsi.

In some embodiments, the formation process of the metal gates 226 includes the following operations. A metal layer is formed on the surface of the gate dielectric layer and the surface of the first isolation layer. Excess metal layer is removed through maskless etching, so as to form the metal gates 226 surrounding the plurality of active areas on the surface of the gate dielectric layer arranged on the side walls of the plurality of active areas. In this process, there is no electrical connection between the metal gates 226 on the side walls of adjacent active areas 220, and thus the plurality of metal gates 226 are discrete. A plurality of conductive connection structures that electrically connects the plurality of metal gates arranged in each row in the second direction may be formed subsequently, and the metal gates in the adjacent rows are still disconnected from each other, so as to improve the control capability of the vertical transistors, thereby improving the operational capabilities (reading, writing, and deleting) of the subsequently formed memory.

In some other embodiments, the formation process of the metal gates includes the following operations. A metal layer filling the plurality of first trenches, the plurality of third trenches and the plurality of second trenches is formed on the surface of the gate dielectric layer and on the surface of the first isolation layer. The metal layer is etched back, so as to allow a top surface of the metal layer to be lower than the top surface of each of the plurality of active areas. After the metal layer is etched back, the metal layer filling the plurality of third trenches is cut along the second direction, so as to form the plurality of metal gates surrounding the plurality of active areas on the surface of the gate dielectric layer arranged on the side walls of the plurality of active areas. For the metal gates formed in this manner, the plurality of metal gates arranged in each row in the second direction are connected with each other, and the metal gates arranged in the adjacent rows in the second direction are disconnected from each other.

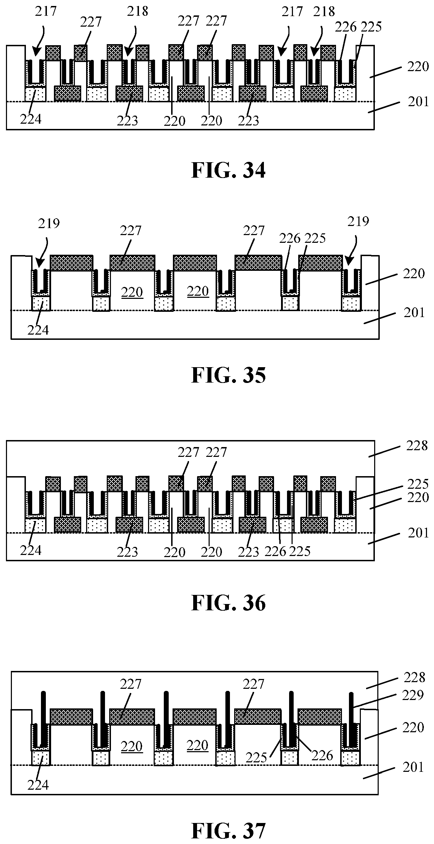

With reference to FIG. 34 and FIG. 35, a source area 227 is formed on the top surface of each of the plurality of active areas 220.

The type of impurity ions doped in the source area 227 is the same as the type of impurity ions doped in the bit line areas 223, but is different from the type of impurity ions doped in the well area of the active areas. The source area 227 is formed through a second ion implantation process. The impurity ions implanted into (doped in) the source area 227 are N-type impurity ions or P-type impurity ions. The P-type impurity ions are one or more of boron ions, gallium ions or indium ions, and the N-type impurity ions are one or more of phosphorus ions, arsenic ions or antimony ions.

In some embodiments, with reference to FIG. 36 and FIG. 37, after the plurality of discrete metal gates 226 are formed, a second isolation layer 228 covering the metal gates 226 and filling the first trenches, the third trenches and the second trenches is formed. A plurality of conductive connection structures extending along the second direction and configured to connect the plurality of metal gates 226 with each other are formed in the second isolation layer 228 in the third trenches.

In some embodiments, in a case that the plurality of formed metal gates arranged in each row in the second direction are initially connected with each other, and the metal gates arranged in the adjacent rows in the second direction are disconnected from each other, the second isolation layer filling the first trenches, the third trenches and the second trenches are directly formed without additional formation of the conductive connection structures.

In the application, a plurality of vertical transistors are formed through the above-mentioned process. Each vertical transistor includes a respective active area 220, a gate dielectric layer 225 arranged on the surface of the side wall of the active area 220, a bit line doped area 223 arranged in the semiconductor substrate at the bottom portion of the second trench, a source area 227 arranged on the top surface of the active area 220, and a metal gate 226 arranged on the surface of the gate dielectric layer on the side wall of the first trench, the second trench, and the third trench and surrounding the active area 220. In the vertical transistor of the specific structure described above, since the source area and the drain area are arranged on the upper and lower sides of the active area, the formed channel area is arranged on the side wall of the active area, so that an area of the semiconductor substrate occupied by the vertical transistor is relatively small, the number of the vertical transistors formed in the unit area can be increased, and the number of the capacitors that are subsequently formed in the unit area and connected to the source area of each transistor can also be increased accordingly, thereby improving the storage capacity and the storage density of the memory. In addition, the vertical transistor of such a specific structure can reduce the body effect, and reduce the leakage current generated by the subsequently formed capacitor into the substrate, thereby improving the electrical performance of the storage device.

In some embodiments, after the source area 227 is formed, the method further includes the following operation. A capacitor connected to the source area 227 is formed on the surface of the semiconductor substrate 201.

In some embodiments, the operation that the capacitor connected to the source area is formed on the surface of the semiconductor substrate includes the following operations. A first dielectric layer is formed on the semiconductor substrate. A plurality of through holes exposing a surface of the source area are formed in the first dielectric layer. A contact plug is formed in each of the plurality of through holes. A second dielectric layer is formed on the first dielectric layer. A capacitor hole exposing the contact plug is formed in the second dielectric layer. The capacitor is formed in the capacitor hole.

In some embodiments, the operation that the capacitor connected to the source area 223 is formed on the surface of the semiconductor substrate 201 includes the following operations. With reference to FIG. 38 and FIG. 39, a first dielectric layer 230 is formed on the second isolation layer 228. A plurality of through holes 231 exposing the surface of the source area 227 are formed in the first dielectric layer 230 and the second isolation layer 228. In some embodiments, the openings of the formed through holes 231 may be widened toward both sides, so as to facilitate the subsequent formation of contact plugs, and to increase the contact area between the top surfaces of the formed contact plugs and the subsequently formed capacitors. With reference to FIG. 40 and FIG. 41, the contact plugs 232 are formed in the through holes, in which the material of the contact plug 232 is metal. With reference to FIG. 42 and FIG. 43, a third dielectric layer 233 is formed on the second dielectric layer 230. The capacitor holes exposing the contact plugs 232 are formed in the third dielectric layer 233. The capacitors 234 are formed in the capacitor holes.

In some embodiments, the capacitor 234 includes a lower electrode layer, a dielectric layer arranged on the lower electrode layer, and an upper electrode layer arranged on the dielectric layer.

In some embodiments, the material of the dielectric layer may be a high-K dielectric material, so as to improve the capacitance value of the capacitor per unit area. The high-K dielectric material includes one of HfO₂, TiO₂, HfZrO, HfSiNO, Ta₂O₅, ZrO₂, ZrSiO₂, Al₂O₃, SrTiO₃, or BaSrTiO, or a stack structure formed by two or more groups composed of the above materials.

In some embodiments, the materials of the upper electrode layer and the lower electrode layer may be one of tungsten, titanium, nickel, aluminum, platinum, titanium nitride, N-type polysilicon and P-type polysilicon, or a stack structure formed by two or more groups composed of the above materials, and may also include compounds formed by one or two of metal nitrides and metal silicides, such as titanium nitride, titanium silicide, titanium silicide, titanium silicon nitride (TiSiₓN_{y}), etc.

In some other embodiments, the capacitors may also be formed through an existing double-sided capacitor forming process.

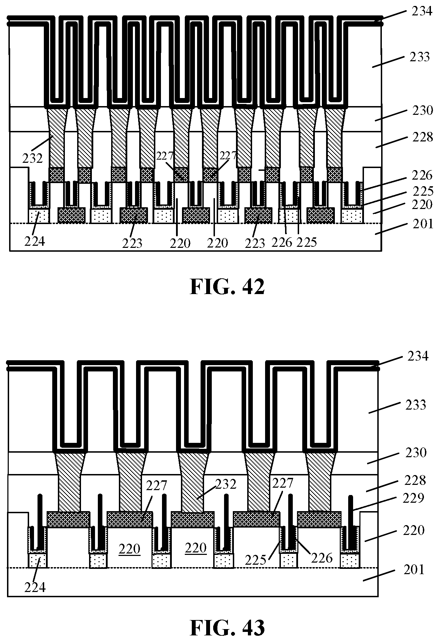

Some embodiments of the application further provide a storage device. With reference to FIG. 42 and FIG. 43 and with reference to FIG, 19 to FIG. 21, the storage device includes:
a semiconductor substrate 201, in which a plurality of active areas 220 are formed in the semiconductor substrate 201, the plurality of active areas 220 are spaced apart from each other by a plurality of first trenches 217 and a plurality of second trenches 218 extending along a first direction and a plurality of third trenches 219 extending along a second direction, the plurality of first trenches 217 and the plurality of second trenches 218 communicate with the plurality of third trenches 219, the plurality of first trenches 217 and the plurality of second trenches 218 are spaced apart from each other in the second direction, a depth of each of the plurality of second trenches 218 is less than a depth of each of the plurality of first trenches 217, and a depth of a region of each of the plurality of third trenches other than a communication region of each of the plurality of third trenches 219 with each of the plurality of second trenches 218 is greater than the depth of each of the plurality of second trenches 218;
a bit line doped area 223 arranged in the semiconductor substrate 201 at a bottom portion of each of the plurality of second trenches 218 and at a bottom portion of the communication region of each of the plurality of third trenches 219 with each of the plurality of second trenches 218;
a first isolation layer 224 arranged in each of the plurality of first trenches 217 and each of the plurality of third trenches 219, in which a surface of the first isolation layer 224 is lower than a surface of each of the plurality of active areas 220;
a gate dielectric layer 225 arranged on the surfaces of the plurality of active areas 220 and surrounding the plurality of active areas 220;
a plurality of metal gates 226 arranged on a surface of the gate dielectric layer 225 on side walls of the plurality of active areas 220 and surrounding the plurality of active areas 220, in which a top surface of each of the plurality of metal gates 226 is lower than a top surface of each of the plurality of active areas 220; and
a source area 227 arranged on the top surface of each of the plurality of active areas 220.

In some embodiments, a width of the bit line doped area 223 is greater than or equal to a width of the bottom portion of each of the plurality of second trenches 218.

In some embodiments, impurity ions doped in the bit line doped area 223 are N-type impurity ions or P-type impurity ions.

In some embodiments, a type of impurity ions doped in the source area 227 is the same as a type of the impurity ions doped in the bit line doped area 223.

In some embodiments, the plurality of metal gates 226 are arranged on the surface of the gate dielectric layer on the side walls of the plurality of active areas and surround the plurality of active areas, and each of the plurality of first trenches, each of the plurality of third trenches, and each of the plurality of second trenches are partially filled with the plurality of metal gates 226.

In some embodiments, the storage device further includes a second isolation layer 228 covering the plurality of metal gates 226 and filling the plurality of first trenches, the plurality of third trenches, and plurality of the second trenches; and a plurality of conductive connection structures 229 arranged in the second isolation layer 228 in the plurality of third trenches, extending along the second direction, and configured to connect the plurality of metal gates with each other (with reference to FIG. 43).

The plurality of first trenches, the plurality of third trenches and the plurality of second trenches are completely filled with the plurality of metal gates, each of the plurality of metal gates is lower than the top surface of each of the plurality of active areas, and a portion of the plurality of metal gates in the plurality of third trenches is cut along the second direction.

The storage device further includes a capacitor 234 arranged on the semiconductor substrate 201 and connected to the source area 227.

It should be noted that the limitations or descriptions of the same or similar structures in this embodiment (storage device) and the above embodiments (the method for forming the storage device) will not be repeated in this embodiment. For details, reference may be made to the limitations or descriptions in corresponding parts in the above embodiments.

Although some preferred embodiments are disclosed as above, it is not intended to limit the present application. Any person skilled in the art may implement any possible changes or modifications to the technical solutions of the present application by using the methods and technical contents disclosed above.

## Claims

1. A method for forming a DRAM device, the method comprises:
providing a semiconductor substrate (201), and forming a plurality of active areas (220) in the semiconductor substrate (201), wherein the plurality of active areas (220) are spaced apart from each other by a plurality of first trenches (217) and a plurality of second trenches (218) extending along a first direction and a plurality of third trenches (219) extending along a second direction, the plurality of first trenches (217) and the plurality of second trenches (218) communicate with the plurality of third trenches (219), the plurality of first trenches (217) and the plurality of second trenches (218) are spaced apart from each other in the second direction, a depth of each of the plurality of second trenches (218) is less than a depth of each of the plurality of first trenches (217), and a depth of a region of each of the plurality of third trenches (219) other than a communication region of each of the plurality of third trenches (219) with each of the plurality of second trenches (218) is greater than the depth of each of the plurality of second trenches (218);
forming a bit line area (223) in the semiconductor substrate (201) at a bottom portion of each of the plurality of second trenches (218) and at a bottom portion of the communication region of each of the plurality of third trenches (219) with each of the plurality of second trenches (218);
forming a first isolation layer (224) in each of the plurality of first trenches (217) and each of the plurality of third trenches (219), wherein a surface of the first isolation layer (224) is lower than a surface of each of the plurality of active areas (220);
forming a gate dielectric layer (225) surrounding the plurality of active areas (220) on surfaces of the plurality of active areas (220);
forming, on a surface of the gate dielectric layer (225) arranged on side walls of the plurality of active areas (220), a plurality of metal gates (226) surrounding the plurality of active areas (220), wherein a top surface of each of the plurality of metal gates (226) is lower than a top surface of each of the plurality of active areas (220);
forming a source area (227) on the top surface of each of the plurality of active areas (220); and
forming a capacitor (234) connected to the source area (227) on the surface of the semiconductor substrate (201),
wherein forming the plurality of metal gates (226) comprises: forming a metal layer on the surface of the gate dielectric layer (225) and the surface of the first isolation layer (224); and removing an excess portion of the metal layer through maskless etching to form the plurality of metal gates (226) surrounding the plurality of active areas (220) on the surface of the gate dielectric layer (225) arranged on the side walls of the plurality of active areas (220).

2. The method for forming the DRAM device according to claim 1, wherein a width of the bit line area (223) is greater than or equal to a width of the bottom portion of each of the plurality of second trenches (218).

3. The method for forming the DRAM device according to claim 2, wherein the bit line area (223) is formed through a first ion implantation process, and impurity ions implanted through the first ion implantation process are N-type impurity ions or P-type impurity ions,
wherein the method further comprises:
before performing the first ion implantation process, forming a protective layer (221) on side walls and bottom surfaces of the plurality of first trenches (217), side walls and bottom surfaces of the plurality of third trenches (219), and side walls and bottom surfaces of the plurality of second trenches (218);
after forming the protective layer (221), forming a mask layer (222) on a surface of the semiconductor substrate (201), wherein the mask layer (222) is provided with a plurality of openings exposing the semiconductor substrate (201) at the bottom portion of each of the plurality of second trenches (218) and at the bottom portion of the communication region of each of the plurality of third trenches (219) with each of the plurality of second trenches (218); and
performing, by using the mask layer (222) as a mask, the first ion implantation process on the semiconductor substrate (201) at the bottom portion of each of the plurality of second trenches (218) and at the bottom portion of the communication region of each of the plurality of third trenches (219) with each of the plurality of second trenches (218) along the plurality of openings, to form the bit line area (223) in the semiconductor substrate (201) at the bottom portion of each of the plurality of second trenches (218) and at the bottom portion of the communication region of each of the plurality of third trenches (219) with each of the plurality of second trenches (218),
wherein the method further comprises: after forming the plurality of metal gates (226), forming a second isolation layer (228) covering the plurality of metal gates (226) and filling the plurality of first trenches (217), the plurality of third trenches (219) and the plurality of second trenches (218); and forming, in the second isolation layer (228) in the plurality of third trenches (219), a plurality of conductive connection structures (229) extending along the second direction and configured to connect the plurality of metal gates (226) with each other.

4. The method for forming the DRAM device according to claim 1, wherein the source area (227) is formed through a second ion implantation process.

5. The method for forming the DRAM device according to claim 2, wherein a type of impurity ions doped in the source area (227) is the same as a type of impurity ions doped in the bit line area (223).

6. The method for forming the DRAM device according to claim 1, wherein forming the plurality of metal gates (226) comprises: forming a metal layer filling the plurality of first trenches (217), the plurality of third trenches (219) and the plurality of second trenches (218) on the surface of the gate dielectric layer (225) and on the surface of the first isolation layer (224); etching back the metal layer to allow a top surface of the metal layer to be lower than the top surface of each of the plurality of active areas (220); and after etching back the metal layer, cutting the metal layer filing the plurality of third trenches (219) along the second direction to form the plurality of metal gates (226) surrounding the plurality of active areas (220) on the surface of the gate dielectric layer (225) arranged on the side walls of the plurality of active areas (220).

7. The method for forming the DRAM device according to claim 1,
wherein forming the capacitor (234) connected to the source area (227) on the surface of the semiconductor substrate (201) comprises: forming a first dielectric layer (230) on the semiconductor substrate (201); forming a plurality of through holes (231) exposing a surface of the source area (227) in the first dielectric layer (230); forming a contact plug (232) in each of the plurality of through holes (231); forming a second dielectric layer on the first dielectric layer (230); forming a capacitor hole exposing the contact plug (232) in the second dielectric layer; and forming the capacitor (234) in the capacitor hole.

8. The method for forming the DRAM device according to claim 1, wherein the plurality of active areas (220) are arranged in rows and columns,
wherein forming the plurality of active areas (220) comprises: forming, on the semiconductor substrate (201), a plurality of first mask patterns (209) arranged parallel to each other and extending along the first direction, wherein a plurality of first openings (210) and a plurality of second openings (214) are alternately arranged between any two of the plurality of first mask patterns (209) adjacent to each other, and a width of each of the plurality of first openings (210) is greater than a width of each of the plurality of second openings (214); forming, on the plurality of first mask patterns (209), a plurality of second mask patterns arranged parallel to each other and extending along the second direction, wherein a plurality of sixth openings are provided between any two of the plurality of second mask patterns adjacent to each other; etching the plurality of first mask patterns (209) along the plurality of sixth openings by using the plurality of second mask patterns as masks to form a plurality of third openings (215) extending along the second direction in the plurality of first mask patterns (209), wherein a remaining portion of the plurality of first mask patterns (209) is formed as a plurality of discrete etching masks (216); and etching the semiconductor substrate (201) by using the plurality of etching masks (216) as masks to form the plurality of first trenches (217) corresponding to the plurality of first openings (210), the plurality of second trenches (218) corresponding to the plurality of second openings (214), and the plurality of third trenches (219) corresponding to the plurality of third openings (215) in the semiconductor substrate (201), wherein a plurality of areas between the plurality of first trenches (217), the plurality of second trenches (218), and the plurality of third trenches (219) are formed as the plurality of active areas (220), the plurality of first trenches (217) and the plurality of second trenches (218) communicate with the plurality of third trenches (219), the depth of each of the plurality of second trenches (218) is less than the depth of each of the plurality of first trenches (217), and the depth of the region of each of the plurality of third trenches (219) other than the communication region of each of the plurality of third trenches (219) with each of the plurality of second trenches (218) is greater than the depth of each of the plurality of second trenches (218),
wherein the plurality of first mask patterns (209) and the plurality of second mask patterns are formed through a self-aligned double patterning process,
wherein forming the plurality of first mask patterns (209) comprises: forming a first hard mask layer (202) on the semiconductor substrate (201); forming, on the first hard mask layer (202), a plurality of first strip structures (204) extending along the first direction and arranged parallel to each other; forming a first sacrificial spacer layer (206) on side walls and top surfaces of the plurality of first strip structures (204) and on a surface of the first hard mask layer (202) between the plurality of first strip structures (204); filling a first filling layer (207) between the plurality of first strip structures (204); removing the first sacrificial spacer layer (206) on surfaces of the side walls of the plurality of first strip structures (204) to form a plurality of fourth openings (208) between the plurality of first strip structures (204) and the first filling layer (207); etching the first hard mask layer (202) along the plurality of fourth openings (208) to form the plurality of first openings (210) in the first hard mask layer (202); forming a second filling layer filling the plurality of first openings (210); forming, on the second filling layer, a plurality of second strip structures (211) extending along the first direction and arranged parallel to each other, wherein each of the plurality of second strip structures (211) covers the second filling layer in a respective one of the plurality of first openings (210) and a portion of the first hard mask layer (202) on both sides of the respective one of the plurality of first openings (210); forming a second sacrificial spacer layer (212) on side walls and top surfaces of the plurality of second strip structures (211) and on surfaces of the first hard mask layer (202) and the first filling layer (207) between the plurality of second strip structures (211); filling a third filling layer (213) between the plurality of second strip structures (211); removing the second sacrificial spacer layer (212) on surfaces of the side walls of the plurality of second strip structures (211) to form a plurality of fifth openings between the plurality of second strip structures (211) and the third filling layer (213), wherein a width of each of the plurality of fifth openings is less than a width of each of the plurality of fourth openings (208); and etching the first hard mask layer (202) between the plurality of first openings (210) along the plurality of fifth openings to form the plurality of second openings (214) in the first hard mask layer (202), wherein the width of each of the plurality of second openings (214) is less than the width of each of the plurality of first openings (210), and a remaining portion of the first hard mask layer (202) between the plurality of second openings (214) and the plurality of first openings (210) is formed as the plurality of first mask patterns (209).

9. A DRAM device, the DRAM device comprises:
a semiconductor substrate (201), wherein a plurality of active areas (220) are formed in the semiconductor substrate (201), the plurality of active areas (220) are spaced apart from each other by a plurality of first trenches (217) and a plurality of second trenches (218) extending along a first direction and a plurality of third trenches (219) extending along a second direction, the plurality of first trenches (217) and the plurality of second trenches (218) communicate with the plurality of third trenches (219), the plurality of first trenches (217) and the plurality of second trenches (218) are spaced apart from each other in the second direction, a depth of each of the plurality of second trenches (218) is less than a depth of each of the plurality of first trenches (217), and a depth of a region of each of the plurality of third trenches (219) other than a communication region of each of the plurality of third trenches (219) with each of the plurality of second trenches (218) is greater than the depth of each of the plurality of second trenches (218);
a bit line area (223) arranged in the semiconductor substrate (201) at a bottom portion of each of the plurality of second trenches (218) and at a bottom portion of the communication region of each of the plurality of third trenches (219) with each of the plurality of second trenches (218);
a first isolation layer (224) arranged in each of the plurality of first trenches (217) and each of the plurality of third trenches (219), wherein a surface of the first isolation layer (224) is lower than a surface of each of the plurality of active areas (220);
a gate dielectric layer (225) arranged on the surfaces of the plurality of active areas (220) and surrounding the plurality of active areas (220);
a plurality of metal gates (226) arranged on a surface of the gate dielectric layer (225) on side walls of the plurality of active areas (220) and surrounding the plurality of active areas (220), wherein a top surface of each of the plurality of metal gates (226) is lower than a top surface of each of the plurality of active areas (220);
a source area (227) arranged on the top surface of each of the plurality of active areas (220); and
a capacitor (234) arranged on the semiconductor substrate (201) and connected to the source area (227);
wherein the plurality of first trenches (217), the plurality of third trenches (219), and the plurality of second trenches (218) are completely filled with the plurality of metal gates (226), each of the plurality of metal gates (226) is lower than the top surface of each of the plurality of active areas (220), and a portion of the plurality of metal gates (226) in the plurality of third trenches (219) is cut along the second direction.

10. The DRAM device according to claim 9, wherein a width of the bit line area (223) is greater than or equal to a width of the bottom portion of each of the plurality of second trenches (218),
wherein impurity ions doped in the bit line area (223) are N-type impurity ions or P-type impurity ions.

11. The DRAM device according to claim 9, wherein a type of impurity ions doped in the source area (227) is the same as a type of impurity ions doped in the bit line area (223).

12. The DRAM device according to claim 9, wherein the plurality of metal gates (226) are arranged on the surface of the gate dielectric layer (225) on the side walls of the plurality of active areas (220) and surround the plurality of active areas (220),
wherein the DRAM device further comprises: a second isolation layer (228) covering the plurality of metal gates (226) and filling the plurality of first trenches (217), the plurality of third trenches (219), and the plurality of second trenches (218); and a plurality of conductive connection structures (229) arranged in the second isolation layer (228) in the plurality of third trenches (219), extending along the second direction, and configured to connect the plurality of metal gates (226) with each other.

## Patentansprüche

1. Verfahren zum Herstellen einer DRAM-Vorrichtung, wobei das Verfahren Folgendes umfasst:
Bereitstellen eines Halbleitersubstrats (201) und Ausbilden mehrerer aktiver Bereiche (220) in dem Halbleitersubstrat (201), wobei die mehreren aktiven Bereiche (220) durch mehrere erste Gräben (217) und mehrere zweite Gräben (218), die sich entlang einer ersten Richtung erstrecken, und mehrere dritte Gräben (219), die sich entlang einer zweiten Richtung erstrecken, voneinander beabstandet sind, wobei die mehreren ersten Gräben (217) und die mehreren zweiten Gräben (218) mit den mehreren dritten Gräben (219) kommunizieren, wobei die mehreren ersten Gräben (217) und die mehreren zweiten Gräben (218) in der zweiten Richtung voneinander beabstandet sind, wobei eine Tiefe jedes der mehreren zweiten Gräben (218) geringer als eine Tiefe jedes der mehreren ersten Gräben (217) ist, wobei eine Tiefe eines Bereichs jedes der mehreren dritten Gräben (219) außer einem Kommunikationsbereich jedes der mehreren dritten Gräben (219) mit jedem der mehreren zweiten Gräben (218) größer ist als die Tiefe jedes der mehreren zweiten Gräben (218);
Ausbilden eines Bitleitungsbereichs (223) in dem Halbleitersubstrat (201) an einem unteren Abschnitt jedes der mehreren zweiten Gräben (218) und an einem unteren Abschnitt des Kommunikationsbereichs jedes der mehreren dritten Gräben (219) mit jedem der mehreren zweiten Gräben (218);
Ausbilden einer ersten Isolationsschicht (224) in jedem der mehreren ersten Gräben (217) und jedem der mehreren dritten Gräben (219), wobei eine Oberfläche der ersten Isolationsschicht (224) tiefer liegt als eine Oberfläche jedes der mehreren aktiven Bereiche (220);
Ausbilden einer Gate-Dielektrikumsschicht (225), die die mehreren aktiven Bereiche (220) auf Oberflächen der mehreren aktiven Bereiche (220) umgibt;
Ausbilden mehrerer Metallgates (226), die die mehreren aktiven Bereiche (220) umgeben, auf einer Oberfläche der Gate-Dielektrikumsschicht (225), die an Seitenwänden der mehreren aktiven Bereiche (220) angeordnet ist, wobei eine Oberseite jedes der mehreren Metallgates (226) tiefer liegt als eine Oberseite jedes der mehreren aktiven Bereiche (220);
Ausbilden eines Source-Bereichs (227) auf der Oberseite jedes der mehreren aktiven Bereiche (220); und
Ausbilden eines Kondensators (234), der mit dem Source-Bereich (227) auf der Oberfläche des Halbleitersubstrats (201) verbunden ist,
wobei das Ausbilden der mehreren Metallgates (226) Folgendes umfasst: Ausbilden einer Metallschicht auf der Oberfläche der Gate-Dielektrikumsschicht (225) und der Oberfläche der ersten Isolationsschicht (224); und Entfernen eines überschüssigen Abschnitts der Metallschicht durch maskenloses Ätzen, um die mehreren Metallgates (226) zu erzeugen, die die mehreren aktiven Bereiche (220) auf der Oberfläche der Gate-Dielektrikumsschicht (225) umgeben, die an den Seitenwänden der mehreren aktiven Bereiche (220) angeordnet ist.

2. Verfahren zum Herstellen der DRAM-Vorrichtung nach Anspruch 1, wobei eine Breite des Bitleitungsbereichs (223) größer oder gleich einer Breite des unteren Abschnitts jedes der mehreren zweiten Gräben (218) ist.

3. Verfahren zum Herstellen der DRAM-Vorrichtung nach Anspruch 2, wobei der Bitleitungsbereich (223) durch einen ersten Ionenimplantationsprozess hergestellt wird und die durch den ersten Ionenimplantationsprozess implantierten Fremdionen N-Typ-Fremdionen oder P-Typ-Fremdionen sind,
wobei das Verfahren ferner Folgendes umfasst:
Ausbilden einer Schutzschicht (221) an den Seitenwänden und Unterseiten der mehreren ersten Gräben (217), den Seitenwänden und Unterseiten der mehreren dritten Gräben (219) und den Seitenwänden und Unterseiten der mehreren zweiten Gräben (218) vor der Durchführung des ersten Ionenimplantationsprozesses;
Ausbilden einer Maskenschicht (222) auf einer Oberfläche des Halbleitersubstrats (201) nach dem Ausbilden der Schutzschicht (221), wobei die Maskenschicht (222) mit mehreren Öffnungen versehen ist, die das Halbleitersubstrat (201) am unteren Abschnitt jedes der mehreren zweiten Gräben (218) und am unteren Abschnitt des Kommunikationsbereichs jedes der mehreren dritten Gräben (219) mit jedem der mehreren zweiten Gräben (218) freilegen; und
Durchführen des ersten Ionenimplantationsprozesses unter Verwendung der Maskenschicht (222) als Maske auf dem Halbleitersubstrat (201) am unteren Abschnitt jedes der mehreren zweiten Gräben (218) und am unteren Abschnitt des Kommunikationsbereichs jedes der mehreren dritten Gräben (219) mit jedem der mehreren zweiten Gräben (218) entlang der mehreren Öffnungen, um den Bitleitungsbereich (223) in dem Halbleitersubstrat (201) am unteren Abschnitt jedes der mehreren zweiten Gräben (218) und am unteren Abschnitt des Kommunikationsbereichs jedes der mehreren dritten Gräben (219) mit jedem der mehreren zweiten Gräben (218) zu erzeugen,
wobei das Verfahren ferner Folgendes umfasst: Ausbilden einer zweiten Isolationsschicht (228) nach dem Ausbilden der mehreren Metallgates (226), die die mehreren Metallgates (226) bedeckt und die mehreren ersten Gräben (217), die mehreren dritten Gräben (219) und die mehreren zweiten Gräben (218) ausfüllt; und Ausbilden mehrerer leitfähiger Verbindungsstrukturen (229) in der zweiten Isolationsschicht (228) in den mehreren dritten Gräben (219), die sich entlang der zweiten Richtung erstrecken und dazu konfiguriert sind, die mehreren Metallgates (226) miteinander zu verbinden.

4. Verfahren zum Herstellen der DRAM-Vorrichtung nach Anspruch 1, wobei der Source-Bereich (227) durch einen zweiten Ionenimplantationsprozess hergestellt wird.

5. Verfahren zum Herstellen der DRAM-Vorrichtung nach Anspruch 2, wobei eine Art von Fremdionen, mit der der Source-Bereich (227) dotiert ist, dieselbe ist wie eine Art von Fremdionen, mit der der Bitleitungsbereich (223) dotiert ist.

6. Verfahren zum Herstellen der DRAM-Vorrichtung nach Anspruch 1, wobei das Ausbilden der mehreren Metallgates (226) Folgendes umfasst: Ausbilden einer Metallschicht, die die mehreren ersten Gräben (217), die mehreren dritten Gräben (219) und die mehreren zweiten Gräben (218) auf der Oberfläche der Gate-Dielektrikumsschicht (225) und auf der Oberfläche der ersten Isolationsschicht (224) ausfüllt; Rückätzen der Metallschicht, damit eine Oberseite der Metallschicht tiefer als die Oberseite jedes der mehreren aktiven Bereiche (220) liegt; und Schneiden der Metallschicht, die die mehreren dritten Gräben (219) ausfüllt, entlang der zweiten Richtung nach dem Rückätzen der Metallschicht, um die mehreren Metallgates (226) zu erzeugen, die die mehreren aktiven Bereiche (220) auf der Oberfläche der Gate-Dielektrikumsschicht (225) umgeben, die an den Seitenwänden der mehreren aktiven Bereiche (220) angeordnet ist.

7. Verfahren zum Herstellen der DRAM-Vorrichtung nach Anspruch 1,
wobei das Ausbilden des mit dem Source-Bereich (227) verbundenen Kondensators (234) auf der Oberfläche des Halbleitersubstrats (201) Folgendes umfasst: Ausbilden einer ersten dielektrischen Schicht (230) auf dem Halbleitersubstrat (201); Ausbilden mehrerer Durchgangslöcher (231), die eine Oberfläche des Source-Bereichs (227) in der ersten dielektrischen Schicht (230) freilegen; Ausbilden eines Kontaktsteckers (232) in jedem der mehreren Durchgangslöcher (231); Ausbilden einer zweiten dielektrischen Schicht auf der ersten dielektrischen Schicht (230); Ausbilden eines Kondensatorlochs, das den Kontaktstecker (232) in der zweiten dielektrischen Schicht freilegt; und Ausbilden des Kondensators (234) in dem Kondensatorloch.

8. Verfahren zum Herstellen der DRAM-Vorrichtung nach Anspruch 1, wobei die mehreren aktiven Bereiche (220) in Zeilen und Spalten angeordnet sind,
wobei das Ausbilden der mehreren aktiven Bereiche (220) Folgendes umfasst: Ausbilden mehrerer erster Maskenmuster (209) auf dem Halbleitersubstrat (201), die parallel zueinander angeordnet sind und sich entlang der ersten Richtung erstrecken, wobei mehrere erste Öffnungen (210) und mehrere zweite Öffnungen (214) abwechselnd zwischen jeweils zwei benachbarten der mehreren ersten Maskenmuster (209) angeordnet sind, wobei eine Breite jeder der mehreren ersten Öffnungen (210) größer ist als eine Breite jeder der mehreren zweiten Öffnungen (214); Ausbilden mehrerer zweiter Maskenmustern auf den mehreren ersten Maskenmustern (209), die parallel zueinander angeordnet sind und sich entlang der zweiten Richtung erstrecken, wobei mehrere sechste Öffnungen zwischen jeweils zwei benachbarten der mehreren zweiten Maskenmuster vorgesehen sind; Ätzen der mehreren ersten Maskenmuster (209) entlang der mehreren sechsten Öffnungen unter Verwendung der mehreren zweiten Maskenmuster als Masken, um mehrere dritte Öffnungen (215) zu erzeugen, die sich entlang der zweiten Richtung in den mehreren ersten Maskenmustern (209) erstrecken, wobei ein verbleibender Abschnitt der mehreren ersten Maskenmuster (209) als mehrere diskrete Ätzmasken (216) ausgebildet wird; und Ätzen des Halbleitersubstrats (201) unter Verwendung der mehreren Ätzmasken (216) als Masken, um die mehreren ersten Gräben (217) entsprechend den mehreren ersten Öffnungen (210), die mehreren zweiten Gräben (218) entsprechend den mehreren zweiten Öffnungen (214) und die mehreren dritten Gräben (219) entsprechend den mehreren dritten Öffnungen (215) in dem Halbleitersubstrat (201) zu erzeugen, wobei mehrere Bereiche zwischen den mehreren ersten Gräben (217), den mehreren zweiten Gräben (218) und den mehreren dritten Gräben (219) als die mehreren aktiven Bereiche (220) ausgebildet werden, wobei die mehreren ersten Gräben (217) und die mehreren zweiten Gräben (218) mit den mehreren dritten Gräben (219) kommunizieren, wobei die Tiefe jedes der mehreren zweiten Gräben (218) geringer ist als die Tiefe jedes der mehreren ersten Gräben (217), wobei die Tiefe des Bereichs jedes der mehreren dritten Gräben (219) außer dem Kommunikationsbereich jedes der mehreren dritten Gräben (219) mit jedem der mehreren zweiten Gräben (218) größer ist als die Tiefe jedes der mehreren zweiten Gräben (218),
wobei die mehreren ersten Maskenmuster (209) und die mehreren zweiten Maskenmuster durch einen selbstausgerichteten Doppelstrukturierungsprozess hergestellt werden,
wobei das Ausbilden der mehreren ersten Maskenmuster (209) Folgendes umfasst: Ausbilden einer ersten Hartmaskenschicht (202) auf dem Halbleitersubstrat (201); Ausbilden mehrerer erster Streifenstrukturen (204) auf der ersten Hartmaskenschicht (202), die sich entlang der ersten Richtung erstrecken und parallel zueinander angeordnet sind; Ausbilden einer ersten Opfer-Abstandsschicht (206) auf Seitenwänden und Oberseiten der mehreren ersten Streifenstrukturen (204) und auf einer Oberfläche der ersten Hartmaskenschicht (202) zwischen den mehreren ersten Streifenstrukturen (204); Ausfüllen einer ersten Füllschicht (207) zwischen den mehreren ersten Streifenstrukturen (204); Entfernen der ersten Opfer-Abstandsschicht (206) auf den Oberflächen der Seitenwände der mehreren ersten Streifenstrukturen (204), um mehrere vierte Öffnungen (208) zwischen den mehreren ersten Streifenstrukturen (204) und der ersten Füllschicht (207) zu erzeugen; Ätzen der ersten Hartmaskenschicht (202) entlang den mehreren vierten Öffnungen (208), um die mehreren ersten Öffnungen (210) in der ersten Hartmaskenschicht (202) zu erzeugen; Ausbilden einer zweiten Füllschicht, die die mehreren ersten Öffnungen (210) ausfüllt; Ausbilden mehrerer zweiter Streifenstrukturen (211) auf der zweiten Füllschicht werden, die sich entlang der ersten Richtung erstrecken und parallel zueinander angeordnet sind, wobei jede der mehreren zweiten Streifenstrukturen (211) die zweite Füllschicht in einer jeweiligen der mehreren ersten Öffnungen (210) und einen Abschnitt der ersten Hartmaskenschicht (202) auf beiden Seiten der jeweiligen der mehreren ersten Öffnungen (210) abdeckt; Ausbilden einer zweiten Opfer-Abstandsschicht (212) auf Seitenwänden und Oberseiten der mehreren zweiten Streifenstrukturen (211) und auf Oberflächen der ersten Hartmaskenschicht (202) und der ersten Füllschicht (207) zwischen den mehreren zweiten Streifenstrukturen (211); Ausfüllen einer dritten Füllschicht (213) zwischen den mehreren zweiten Streifenstrukturen (211); Entfernen der zweiten Opfer-Abstandsschicht (212) auf den Oberflächen der Seitenwände der mehreren zweiten Streifenstrukturen (211), um mehrere fünfte Öffnungen zwischen den mehreren zweiten Streifenstrukturen (211) und der dritten Füllschicht (213) zu erzeugen, wobei eine Breite jeder der mehreren fünften Öffnungen geringer ist als eine Breite jeder der mehreren vierten Öffnungen (208) ist; und Ätzen der ersten Hartmaskenschicht (202) zwischen den mehreren ersten Öffnungen (210) entlang den mehreren fünften Öffnungen, um die mehreren zweiten Öffnungen (214) in der ersten Hartmaskenschicht (202) zu erzeugen, wobei die Breite jeder der mehreren zweiten Öffnungen (214) geringer ist als die Breite jeder der mehreren ersten Öffnungen (210), und wobei ein verbleibender Abschnitt der ersten Hartmaskenschicht (202) zwischen den mehreren zweiten Öffnungen (214) und den mehreren ersten Öffnungen (210) als die mehreren ersten Maskenmuster (209) ausgebildet wird.

9. DRAM-Vorrichtung, wobei die DRAM-Vorrichtung Folgendes umfasst:
ein Halbleitersubstrat (201), wobei mehrere aktive Bereiche (220) in dem Halbleitersubstrat (201) ausgebildet sind, wobei die mehreren aktiven Bereiche (220) durch mehrere erste Gräben (217) und mehrere zweite Gräben (218), die sich entlang einer ersten Richtung erstrecken, und mehrere dritte Gräben (219), die sich entlang einer zweiten Richtung erstrecken, voneinander beabstandet sind, wobei die mehreren ersten Gräben (217) und die mehreren zweiten Gräben (218) mit den mehreren dritten Gräben (219) kommunizieren, wobei die mehreren ersten Gräben (217) und die mehreren zweiten Gräben (218) in der zweiten Richtung voneinander beabstandet sind, wobei eine Tiefe jedes der mehreren zweiten Gräben (218) geringer ist als eine Tiefe jedes der mehreren ersten Gräben (217), wobei eine Tiefe eines Bereichs jedes der mehreren dritten Gräben (219) außer einem Kommunikationsbereich jedes der mehreren dritten Gräben (219) mit jedem der mehreren zweiten Gräben (218) größer ist als die Tiefe jedes der mehreren zweiten Gräben (218);
einen Bitleitungsbereich (223), der in dem Halbleitersubstrat (201) an einem unteren Abschnitt jedes der mehreren zweiten Gräben (218) und an einem unteren Abschnitt des Kommunikationsbereichs jedes der mehreren dritten Gräben (219) mit jedem der mehreren zweiten Gräben (218) angeordnet ist;
eine erste Isolationsschicht (224), die in jedem der mehreren ersten Gräben (217) und jedem der mehreren dritten Gräben (219) angeordnet ist, wobei eine Oberfläche der ersten Isolationsschicht (224) tiefer liegt als eine Oberfläche jedes der mehreren aktiven Bereiche (220);
eine Gate-Dielektrikumsschicht (225), die auf den Oberflächen der mehreren aktiven Bereiche (220) angeordnet ist und die mehreren aktiven Bereiche (220) umgibt;
mehrere Metallgates (226), die auf einer Oberfläche der Gate-Dielektrikumsschicht (225) an Seitenwänden der mehreren aktiven Bereiche (220) angeordnet sind und die mehreren aktiven Bereiche (220) umgeben, wobei eine Oberseite jedes der mehreren Metallgates (226) tiefer liegt als eine Oberseite jedes der mehreren aktiven Bereiche (220);
einen Source-Bereich (227), der auf der Oberseite jedes der mehreren aktiven Bereiche (220) angeordnet ist; und
einen Kondensator (234), der auf dem Halbleitersubstrat (201) angeordnet und mit dem Source-Bereich (227) verbunden ist;
wobei die mehreren ersten Gräben (217), die mehreren dritten Gräben (219) und die mehreren zweiten Gräben (218) vollständig mit den mehreren Metallgates (226) gefüllt sind, wobei jedes der mehreren Metallgates (226) tiefer liegt als die Oberseite jedes der mehreren aktiven Bereiche (220), und wobei ein Abschnitt der mehreren Metallgates (226) in den mehreren dritten Gräben (219) entlang der zweiten Richtung geschnitten ist.

10. DRAM-Vorrichtung nach Anspruch 9, wobei eine Breite des Bitleitungsbereichs (223) größer oder gleich einer Breite des unteren Abschnitts jedes der mehreren zweiten Gräben (218) ist, wobei Fremdionen, mit denen der Bitleitungsbereich (223) dotiert ist, N-Typ-Fremdionen oder P-Typ-Fremdionen sind.

11. DRAM-Vorrichtung nach Anspruch 9, wobei eine Art von Fremdionen, mit der der Source-Bereich (227) dotiert ist, dieselbe ist wie eine Art von Fremdionen, mit der der Bitleitungsbereich (223) dotiert ist.

12. DRAM-Vorrichtung nach Anspruch 9, wobei die mehreren Metallgates (226) auf der Oberfläche der Gate-Dielektrikumsschicht (225) an den Seitenwänden der mehreren aktiven Bereiche (220) angeordnet sind und die mehreren aktiven Bereiche (220) umgeben,
wobei die DRAM-Vorrichtung ferner Folgendes umfasst: eine zweite Isolationsschicht (228), die die mehreren Metallgates (226) bedeckt und die mehreren ersten Gräben (217), die mehreren dritten Gräben (219) und die mehreren zweiten Gräben (218) ausfüllt; und mehrere leitfähige Verbindungsstrukturen (229), die in der zweiten Isolationsschicht (228) in den mehreren dritten Gräben (219) angeordnet sind, sich entlang der zweiten Richtung erstrecken und dazu konfiguriert sind, die mehreren Metallgates (226) miteinander zu verbinden.

## Revendications

1. Procédé de formation d'un dispositif DRAM, le procédé comprenant :
fournir un substrat semi-conducteur (201), et former une pluralité de zones actives (220) dans le substrat semi-conducteur (201), dans lequel la pluralité de zones actives (220) sont séparées les unes des autres par une pluralité de premières tranchées (217) et une pluralité de deuxièmes tranchées (218) s'étendant dans une première direction et une pluralité de troisièmes tranchées (219) s'étendant dans une deuxième direction, la pluralité de premières tranchées (217) et la pluralité de deuxièmes tranchées (218) communiquent avec la pluralité de troisièmes tranchées (219), la pluralité de premières tranchées (217) et la pluralité de deuxièmes tranchées (218) sont séparées les unes des autres dans la deuxième direction, une profondeur de chacune de la pluralité de deuxièmes tranchées (218) est inférieure à une profondeur de chacune de la pluralité de premières tranchées (217), et une profondeur d'une région de chacune de la pluralité de troisièmes tranchées (219) autre qu'une région de communication de chacune de la pluralité de troisièmes tranchées (219) avec chacune de la pluralité de deuxièmes tranchées (218) est supérieure à la profondeur de chacune de la pluralité de deuxièmes tranchées (218) ;
former une zone de ligne de bits (223) dans le substrat semi-conducteur (201) à une partie inférieure de chacune de la pluralité de deuxième tranchées (218) et à une partie inférieure de la région de communication de chacune de la pluralité de troisième tranchées (219) avec chacune de la pluralité de deuxième tranchées (218) ;
former une première couche isolante (224) dans chacune de la pluralité de premières tranchées (217) et chacune de la pluralité de troisièmes tranchées (219), dans lequel une surface de la première couche isolante (224) est inférieure à une surface de chacune de la pluralité de zones actives (220) ;
former une couche diélectrique de grille (225) entourant la pluralité de zones actives (220) sur des surfaces de la pluralité de zones actives (220) ;
former, sur une surface de la couche diélectrique de grille (225) disposée sur des parois latérales de la pluralité de zones actives (220), une pluralité de grilles métalliques (226) entourant la pluralité de zones actives (220), dans lequel une surface supérieure de chacune de la pluralité de grilles métalliques (226) est inférieure à une surface supérieure de chacune de la pluralité de zones actives (220) ;
former une zone source (227) sur la surface supérieure de chacune de la pluralité de zones actives (220) ; et
former un condensateur (234) connecté à la zone source (227) sur la surface du substrat semi-conducteur (201),
dans lequel la formation de la pluralité de grilles métalliques (226) comprend : former une couche métallique sur la surface de la couche diélectrique de grille (225) et la surface de la première couche isolante (224) ; et éliminer une partie excessive de la couche métallique par gravure sans masque pour former la pluralité de grilles métalliques (226) entourant la pluralité de zones actives (220) sur la surface de la couche diélectrique de grille (225) disposée sur les parois latérales de la pluralité de zones actives (220).

2. Procédé de formation du dispositif DRAM selon la revendication 1, dans lequel une largeur de la zone de ligne de bits (223) est supérieure ou égale à une largeur de la partie inférieure de chacune de la pluralité de deuxièmes tranchées (218).

3. Procédé de formation du dispositif DRAM selon la revendication 2, dans lequel la zone de ligne de bits (223) est formée par un premier processus d'implantation ionique, et les ions d'impureté implantés par le premier processus d'implantation ionique sont des ions d'impureté de type N ou des ions d'impureté de type P,
dans lequel le procédé comprend en outre :
avant l'exécution du premier processus d'implémentation ionique, former une couche protectrice (221) sur des parois latérales et des surfaces inférieures de la pluralité de premières tranchées (217), des parois latérales et des surfaces inférieures de la pluralité de troisièmes tranchées (219), et des parois latérales et des surfaces inférieures de la pluralité de deuxièmes tranchées (218) ;
après la formation de la couche protectrice (221), former une couche de masque (222) sur une surface du substrat semi-conducteur (201), dans lequel la couche de masque (222) est pourvue d'une pluralité d'ouvertures exposant le substrat semi-conducteur (201) à la partie inférieure de chacune de la pluralité de deuxièmes tranchées (218) et à la partie inférieure de la région de communication de chacune de la pluralité de troisièmes tranchées (219) avec chacune de la pluralité de deuxièmes tranchées (218) ; et
exécuter, en utilisant la couche de masque (222) comme masque, le premier processus d'implantation ionique sur le substrat semi-conducteur (201) à la partie inférieure de chacune de la pluralité de deuxième tranchées (218) et à la partie inférieure de la région de communication de chacune de la pluralité de troisième tranchées (219) avec chacune de la pluralité de deuxième tranchées (218) le long de la pluralité d'ouvertures, pour former la zone de ligne de bits (223) dans le substrat semi-conducteur (201) à la partie inférieure de chacune de la pluralité de deuxième tranchées (218) et à la partie inférieures de la région de communication de chacune de la pluralité de troisième tranchées (219) avec chacune de la pluralité de deuxième tranchées (218),
dans lequel le procédé comprend en outre : après la formation de la pluralité de grilles métalliques (226), former une deuxième couche isolante (228) recouvrant la pluralité de grilles métalliques (226) et remplissant la pluralité de première tranchées (217), la pluralité de troisième tranchées (219) et la pluralité de deuxième tranchées (218) ; et former, dans la deuxième couche isolante (228) dans la pluralité de troisième tranchées (219), une pluralité de structures de connexion conductrices (229) s'étendant selon la deuxième direction et configurées pour connecter la pluralité de grilles métalliques (226) l'une à l'autre.

4. Procédé de formation du dispositif DRAM selon la revendication 1, dans lequel la zone source (227) est formée par un deuxième processus d'implantation ionique.

5. Procédé de formation du dispositif DRAM selon la revendication 2, dans lequel un type d'ions d'impureté dopés dans la zone source (227) est le même qu'un type d'ions d'impureté dopés dans la zone de ligne de bits (223).

6. Procédé de formation du dispositif DRAM selon la revendication 1, dans lequel la formation de la pluralité de grilles métalliques (226) comprend : former une couche métallique remplissant la pluralité de premières tranchées (217), la pluralité de troisièmes tranchées (219) et la pluralité de deuxièmes tranchées (218) sur la surface de la couche diélectrique de grille (225) et sur la surface de la première couche isolante (224) ; graver l'arrière de la couche métallique pour permettre à une surface supérieure de la couche métallique d'être inférieure à la surface supérieure de chacune de la pluralité de zones actives (220) ; et après le gravage de l'arrière de la couche métallique, découper la couche métallique remplissant la pluralité de troisièmes tranchées (219) selon la deuxième direction pour former la pluralité de grilles métalliques (226) entourant la pluralité de zones actives (220) sur la surface de la couche diélectrique de grille (225) disposée sur les parois latérales de la pluralité de zones actives (220).

7. Procédé de formation du dispositif DRAM selon la revendication 1,
dans lequel la formation du condensateur (234) connecté à la zone source (227) sur la surface du substrat semi-conducteur (201) comprend : former une première couche diélectrique (230) sur le substrat semi-conducteur (201) ; former une pluralité de trous traversants (231) exposant une surface de la zone source (227) dans la première couche diélectrique (230) ; former une prise de contact (232) dans chacun des trous traversants (231) ; former une deuxième couche diélectrique sur la première couche diélectrique (230) ; former un trou de condensateur exposant la prise de contact (232) dans la deuxième couche diélectrique ; et former le condensateur (234) dans le trou de condensateur.

8. Procédé de formation du dispositif DRAM selon la revendication 1, dans lequel la pluralité de zones actives (220) est disposée en rangées et en colonnes,
dans lequel la formation de la pluralité de zones actives (220) comprend : former, sur le substrat semi-conducteur (201), une pluralité de premiers motifs de masque (209) disposés parallèlement les uns aux autres et s'étendant dans la première direction, dans lequel une pluralité de premières ouvertures (210) et une pluralité de deuxièmes ouvertures (214) sont disposées de manière alternative entre deux quelconques de la pluralité de premiers motifs de masque (209) adjacents, et une largeur de chacune de la pluralité de premières ouvertures (210) est supérieure à une largeur de chacune de la pluralité de deuxièmes ouvertures (214) ; former, sur la pluralité de premiers motifs de masque (209), une pluralité de deuxièmes motifs de masque disposés parallèlement les uns aux autres et s'étendant dans la deuxième direction, dans lequel une pluralité de sixièmes ouvertures sont disposées entre deux quelconques de la pluralité de deuxièmes motifs de masque adjacents ; graver la pluralité de premiers motifs de masque (209) le long de la pluralité de sixièmes ouvertures en utilisant la pluralité de deuxièmes motifs de masque comme masques pour former une pluralité de troisièmes ouvertures (215) s'étendant selon la deuxième direction dans la pluralité de premiers motifs de masque (209), dans lequel une partie restante de la pluralité de premiers motifs de masque (209) est formée comme une pluralité de masques de gravure (216) discrets ; et graver le substrat semi-conducteur (201) en utilisant la pluralité de masques de gravure (216) comme masques pour former la pluralité de premières tranchées (217) correspondant à la pluralité de premières ouvertures (210), la pluralité de deuxièmes tranchées (218) correspondant à la pluralité de deuxièmes ouvertures (214), et la pluralité de troisièmes tranchées (219) correspondant à la pluralité de troisièmes ouvertures (215) dans le substrat semi-conducteur (201), dans lequel une pluralité de zones entre la pluralité de premières tranchées (217), la pluralité de deuxièmes tranchées (218), et la pluralité de troisièmes tranchées (219) sont formées comme la pluralité de zones actives (220), la pluralité de premières tranchées (217) et la pluralité de deuxièmes tranchées (218) communiquent avec la pluralité de troisièmes tranchées (219), la profondeur de chacune de la pluralité de deuxièmes tranchées (218) est inférieure à la profondeur de chacune de la pluralité de premières tranchées (217), et la profondeur de la région de chacune de la pluralité de troisièmes tranchées (219) autre que la région de communication de chacune de la pluralité de troisièmes tranchées (219) avec chacune de la pluralité de deuxièmes tranchées (218) est supérieure à la profondeur de chacune de la pluralité de deuxièmes tranchées (218),
dans lequel la pluralité de premiers motifs de masque (209) et une pluralité de deuxièmes motifs de masque sont formés par un procédé de formation de double motif auto-aligné,
dans lequel la formation de la pluralité de premiers motifs de masque (209) comprend : former une première couche de masque dure (202) sur le substrat semi-conducteur (201) ; former, sur la première couche de masque dure (202), une pluralité de premières structures en bande (204) s'étendant selon la première direction et disposées parallèlement les unes aux autres ; former une première couche d'espacement sacrificielle (206) sur des parois latérales et des surfaces supérieures de la pluralité de premières structures en bande (204) et sur une surface de la première couche de masque dure (202) entre la pluralité de premières structures en bande (204) ; remplir une première couche de remplissage (207) entre la pluralité de premières structures en bandes (204) ; éliminer la première couche d'espacement sacrificielle (206) sur des surfaces des parois latérales de la pluralité de premières structures en bandes (204) pour former une pluralité de quatrièmes ouvertures (208) entre la pluralité de premières structures en bandes (204) et la première couche de remplissage (207) ; graver la première couche de masque dure (202) le long de la pluralité de quatrièmes ouvertures (208) pour former la pluralité de premières ouvertures (210) dans la première couche de masque dure (202) ; former une deuxième couche de remplissage remplissant la pluralité de premières ouvertures (210) ; former, sur la deuxième couche de remplissage, une pluralité de deuxièmes structures en bande (211) s'étendant selon la première direction et disposées parallèlement les unes aux autres, dans lequel chacune de la pluralité de deuxièmes structures en bande (211) recouvrant la deuxième couche de remplissage dans l'une respective de la pluralité de premières ouvertures (210) et une partie de la première couche de masque dure (202) sur deux côtés de l'une respective de la pluralité de premières ouvertures (210) ; former une deuxième couche d'espacement sacrificielle (212) sur des parois latérales et des surfaces supérieures de la pluralité de deuxièmes structures en bande (211) et sur des surfaces de la première couche de masque dure (202) et de la première couche de remplissage (207) entre la pluralité de deuxièmes structures en bande (211) ; remplir une troisième couche de remplissage (213) entre la pluralité de deuxièmes structures en bande (211) ; éliminer la deuxième couche d'espacement sacrificielle (212) sur des surfaces des parois latérales de la pluralité de deuxièmes structures en bande (211) pour former une pluralité de cinquièmes ouvertures entre la pluralité de deuxièmes structures en bande (211) et la troisième couche de remplissage (213), dans lequel une largeur de chacune de la pluralité de cinquièmes ouvertures est inférieure à une largeur de chacune de la pluralité de quatrièmes ouvertures (208) ; et graver la première couche de masque dure (202) entre la pluralité de premières ouvertures (210) le long de la pluralité des cinquièmes ouvertures pour former la pluralité des deuxièmes ouvertures (214) dans la première couche de masque dure (202), dans lequel la largeur de chacune de la pluralité de deuxièmes ouvertures (214) est inférieure à la largeur de chacune de la pluralité de premières ouvertures (210), et une partie restante de la première couche de masque dure (202) entre la pluralité des deuxièmes ouvertures (214) et la pluralité des premières ouvertures (210) est formée comme la pluralité des premiers motifs de masque (209).

9. Dispositif DRAM, comprenant :
un substrat semi-conducteur (201), dans lequel une pluralité de zones actives (220) sont formées dans le substrat semi-conducteur (201), la pluralité de zones actives (220) sont séparées les unes des autres par une pluralité de premières tranchées (217) et une pluralité de deuxièmes tranchées (218) s'étendant dans une première direction et une pluralité de troisièmes tranchées (219) s'étendant dans une deuxième direction, la pluralité de premières tranchées (217) et la pluralité de deuxièmes tranchées (218) communiquent avec la pluralité de troisièmes tranchées (219), la pluralité de premières tranchées (217) et la pluralité de deuxièmes tranchées (218) sont séparées les unes des autres dans la deuxième direction, une profondeur de chacune de la pluralité de deuxièmes tranchées (218) est inférieure à une profondeur de chacune de la pluralité de premières tranchées (217), et une profondeur d'une région de chacune de la pluralité de troisièmes tranchées (219) autre qu'une région de communication de chacune de la pluralité de troisièmes tranchées (219) avec chacune de la pluralité de deuxièmes tranchées (218) est supérieure à la profondeur de chacune de la pluralité de deuxièmes tranchées (218) ;
une zone de ligne de bits (223) disposée dans le substrat semi-conducteur (201) à une partie inférieure de chacune de la pluralité de deuxième tranchées (218) et à une partie inférieure de la région de communication de chacune de la pluralité de troisième tranchées (219) avec chacune de la pluralité de deuxième tranchées (218) ;
une première couche isolante (224) disposée dans chacune de la pluralité de premières tranchées (217) et chacune de la pluralité de troisièmes tranchées (219), dans laquelle une surface de la première couche isolante (224) est inférieure à une surface de chacune de la pluralité de zones actives (220) ;
une couche diélectrique de grille (225) disposée sur la surface de la pluralité de zones actives (220) et entourant la pluralité de zones actives (220) ;
une pluralité de grilles métalliques (226) disposées sur une surface de la couche diélectrique de grille (225) sur des parois latérales de la pluralité de zones actives (220) et entourant la pluralité de zones actives (220), dans lesquelles une surface supérieure de chacune de la pluralité de grilles métalliques (226) est inférieure à une surface supérieure de chacune de la pluralité de zones actives (220) ;
une zone source (227) disposée sur la surface supérieure de chacune de la pluralité de zones actives (220) ; et
un condensateur (234) disposée sur le substrat semi-conducteur (201) et connecté à la zone source (227) ;
dans lequel la pluralité de premières tranchées (217), la pluralité de troisièmes tranchées (219) et la pluralité de deuxièmes tranchées (218) sont complètement remplies de la pluralité de grilles métalliques (226), chacune de la pluralité de grilles métalliques (226) est inférieure à la surface supérieure de chacune de la pluralité de zones actives (220), et une partie de la pluralité de grilles métalliques (226) dans la pluralité de troisièmes tranchées (219) est coupée selon la deuxième direction.

10. Dispositif DRAM selon la revendication 9, dans lequel une largeur de la zone de ligne de bits (223) est supérieure ou égale à une largeur de la partie inférieure de chacune de la pluralité de deuxièmes tranchées (218), dans lequel les ions d'impureté dopés dans la zone de ligne de bits (223) sont des ions d'impureté de type N ou de type P.

11. Dispositif DRAM selon la revendication 9, dans lequel un type d'ions d'impureté dopés dans la zone source (227) est le même qu'un type d'ions d'impureté dopés dans la zone de ligne de bits (223).

12. Dispositif DRAM selon la revendication 9, dans lequel la pluralité de grilles métalliques (226) sont disposées sur la surface de la couche diélectrique de grille (225) sur les parois latérales de la pluralité de zones actives (220) et entourent la pluralité de zones actives (220),
dans lequel le dispositif DRAM comprend en outre : une deuxième couche isolante (228) recouvrant la pluralité de grilles métalliques (226) et remplissant la pluralité de première tranchées (217), la pluralité de troisième tranchées (219) et la pluralité de deuxième tranchées (218) ; et une pluralité de structures de connexion conductrices (229) disposées dans la deuxième couche isolante (228) dans la pluralité de troisième tranchées (219), s'étendant selon la deuxième direction et configurées pour connecter la pluralité de grilles métalliques (226) l'une à l'autre.
